# EUROPÄISCHE PATENTSCHRIFT

(11) **EP 3 022 739 B1**
(45) Veröffentlichungstag und Bekanntmachung des Hinweises auf die Patenterteilung: **24.10.2018**
(21) Anmeldenummer: 14741854.5
(22) Anmeldetag: 17.07.2014
(51) Int. Cl.: G11C 11/56, G11C 16/16

(54) **VERFAHREN ZUM LÖSCHEN EINES NICHT FLÜCHTIGEN HALBLEITERSPEICHERS MIT IONISIERENDER STRAHLUNG**
METHOD FOR ERASING A NONVOLATILE SEMICONDUCTOR MEMORY USING IONISING RADIATION
PROCÉDÉ POUR EFFACER UNE MÉMOIRE À SEMICONDUCTEURS NON VOLATILE À L'AIDE D'UN RAYONNEMENT IONISANT

(30) Priorität: 19.07.2013 DE 102013214214
(43) Veröffentlichungstag der Anmeldung: 25.05.2016
(73) Patentinhaber: Fraunhofer Gesellschaft zur Förderung der angewandten Forschung E.V., 80686 München (DE)
(72) Erfinder: HÖFFGEN, Stefan, 50259 Pulheim (DE); JÖSTER, Michael, 53879 Euskirchen (DE); KUHNHENN, Jochen, 53879 Euskirchen (DE); KÜNDGEN, Tobias, 53343 Wachtberg (DE); METZGER, Stefan, 52396 Heimbach (DE)
(74) Vertreter: Hersina, Günter
(86) Internationale Anmeldenummer: PCT/EP2014/065393
(87) Internationale Veröffentlichungsnummer: WO 2015/007847

(56) Entgegenhaltungen:
- EP-A2- 0 212 520
- US-A- 4 393 479
- US-A- 5 656 521

## Beschreibung

Die vorliegende Erfindung bezieht sich auf ein Verfahren zum Löschen von Informationen auf einem Halbleiterbaustein mit einer Vielzahl von nicht flüchtigen Speicherelementen durch Bestrahlen desselben mit einer Löschstrahlung, die den Halbleiterbaustein durchdringt. Die vorliegende Erfindung bezieht sich ferner auf eine Vorrichtung zum Löschen von Informationen auf einem elektronischen Halbleiterbaustein mit einer Vielzahl von nicht flüchtigen Speicherelementen mit einer Bestrahlungseinrichtung, die ausgebildet ist, um den Halbleiterbaustein einer Löschstrahlung auszusetzen, insbesondere bezieht sich die Erfindung auf ein Verfahren und eine Vorrichtung zur vollständigen und dauerhaften Vernichtung von auf Datenträgern gespeicherten Informationen mittels direkt oder indirekt ionisierender Strahlung.

Eine Vielzahl von Daten öder Dateien, beispielsweise Geheimdokumente, personenbezogene Daten, sensible Unternehmensdaten, etc. muss nach Ablauf von Aufbewahrungsfristen oder vor einer Entsorgung der Datenträger zuverlässig gelöscht oder vernichtet werden, um gesetzlichen Auflagen zu genügen oder einer unerwünschten Weiterverbreitung der Daten vorzubeugen.

Zur sicheren Vernichtung von elektronisch gespeicherten Informationen: und Daten existieren neben einer häufig unzureichenden Löschung der Informationen oder Daten durch Software drei Verfahren, die eine kommerzielle Anwendung finden. Neben dem sogenannten Degaussen von magnetischen Datenträgern und einem thermischen Vernichten der Informationen oder Daten durch Überschreiten der Curie-Temperatur des Datenträgers kommt für elektronische Speicher der Klasse E gemäß DIN 66399 bislang nur eine mechanische .Zerkleinerung der Datenträger in Betracht. Varianten der mechanischen Zerkleinerung unterscheiden sich hinsichtlich verschiedener Sicherheitsstufen in der Größe der durch das Zerkleinern erzeugten Partikel.

Es können drei Stufen des Säuberns eines Datenträgers und somit der Löschung oder Vernichtung auf dem Datenträger befindlicher Informationen und Daten unterschieden werden. Bei einem logischen Säubern, einer ersten Stufe, besteht nach dem Säubern kein Zugriff mehr auf die Daten über Standard-Interfaces des Datenträgers. Bei einem digitalen Säubern, einer zweiten Stufe, ist nach dem Säubern ein Zugriff auf die Daten in jeglicher digitalen Form verhindert, selbst wenn die Standard-Interfaces umgangen werden. Bei einem analogen Säubern, einer dritten Stufe, ist das analoge Signal, welches die Daten physikalisch codiert, nach dem Säubern so stark degradiert, dass es auch mit fortschrittlichsten analogen Methoden nicht mehr lesbar ist.

Diese drei Stufen stellen in der Reihenfolge logisches Säubern, digitales Säubern und analoges Säubern eine zunehmende Löschsicherheit der Daten bzw. Datenträger vor unbefugtem Zugriff dar. Bei magnetischen Festplatten kann die Abbildung der drei Stufen folgendermaßen erfolgen: Ein logisches Säubern im Sinne eines Löschens der Datei führt zu einer Entfernung der Datei aus dem File Allocation Table (FAT) der Festplatte, die Datei selbst ist jedoch noch auf der Festplatte vorhanden. Ein Zugriff auf die Datei durch einen einfachen Dateiaufruf ist aufgrund des gelöschten Eintrags in der FAT, dem Standard-Interface, verhindert. Das digitale Säubern durch Überschreiben der zu löschenden Datei führt zu einer erneuten Magnetisierung der Festplatte, wobei noch Spuren der ursprünglichen Magnetisierung vorhanden sein können. Durch analoges Säubern durch die vollständige Zerstörung der Magnetisierung der Festplatte durch ein starkes externes Magnetfeld mittels Degaussen oder durch Überschreiten der Curie-Temperatur durch ein Erhitzen der Festplatte. Alternativ hierzu kann eine nahezu analoge Säuberung auch durch eine mechanische Zerkleinerung erfolgen. In Abhängigkeit der bei dem mechanischen Zerkleinern erhaltenen Partikelgröße und der physikalischen Abmessung eines Bits auf dem Datenspeicher ergibt sich die Anzahl an Bits, die pro Partikel möglicherweise wiederhergestellt oder ausgelesen werden können.

Flash-basierte, nicht flüchtige Speicher, z. B. Flash-Electrically-Erasable-Programmable-Read-Only-Memories (EEPROMs) erlangen eine immer größere Bedeutung, sei es als USB-Stick oder als Memory-Card, als eingebauter permanenter Speicher in Smartphones oder Tablet-PC's oder als Ersatz magnetischer Festplatten in Form von Solid State Drives (SSDs). Nicht flüchtige Speicher erfordern zuverlässige Methoden der Vernichtung sensibler Daten. Für optische und magnetische Medien gibt es anerkannte und verifizierte Standards. Bei elektronischen Speichern, beispielsweise bei Flash-Speichern ist zur Erreichung einer analogen Säuberung lediglich eine mechanische Zerkleinerung des Datenträgers bekannt.

Flash-Speicher stellen den am weitesten verbreiteten Typ von nicht flüchtigen Speichern dar, die auf dem Prinzip der Informationsspeicherung mittels Floating-Gates (FG) basiert. Für Flash-Speicher existieren grundsätzlich zwei verschiedene Adressiertechnologien: NOR und NAND. Bei NOR-Flash-Speichern ist ein direktes Schreiben bzw. Lesen auf bzw. von einzelnen Speicherzellen möglich. Somit ist es direkt möglich, Programme von einem NOR-Flash-Speicher aufzurufen. Hingegen, ist die Löschung und Programmierung des Speichers sehr langsam, wobei die Speicher lediglich etwa 10% der Schreib- / Lesezyklen eines NAND-Speichers im Sinne einer Lebensdauer überstehen, bevor sie unbrauchbar werden. Ein typisches Einsatzgebiet für NOR-Flash-Speicher ist das Speichern von Firmware.

In NAND-Flash-Speichern sind mehrere Zellen in Serie zu einer PAGE geschaltet, ähnlich einem namensgebenden NAND-Gate. Die Zellen einer PAGE können nur zusammen gelesen und beschrieben werden. NAND-Speichern haben im Allgemeinen eine höhere Zelldichte und erlauben eine schnellere Programmierung der Zellen und eine höhere Anzahl an Schreib- und Lesezyklen innerhalb der Lebensdauer gegenüber NOR-Speichern. NAND-Speicher werden zur Massenspeicherung eingesetzt und sind ökonomisch betrachtet die momentan am stärksten wachsende Technologie. Allen Flash-Speichern gemeinsam ist, dass das Löschen von Speicherzellen und mithin Daten gleichzeitig nur für einen größeren Block von Speicherzellen möglich ist.

Eine sichere Datenvernichtung durch ein Überschreiben ist nicht möglich, da in NAND-Flash-Speichern, wie sie hauptsächlich zur Massenspeicherung eingesetzt werden, ein Schreiben und damit ein Programmieren einer Speicherzelle vom Zustand 1 auf den Zustand 0 nur Page-weise und ein Löschen durch Versetzen der in den nicht flüchtigen Speicherelementen gespeicherten Bits der Speicherelemente vom logischen Zustand 0 in den Zustand 1 nur Block-weise, d.h. für einen Block von Speicherelementen erfolgen kann. Änderungen an den Daten werden in der Regel nicht durch Überschreiben der physikalischen Speicherzellen durchgeführt, sondern durch Schreiben der Daten an eine andere Stelle des Datenspeichers und durch Freigabe der ursprünglichen Stelle des Datenspeichers. Dadurch bleiben die zu löschenden Daten auf dem Speicher erhalten. Dabei nutzen die Controller der Datenspeicher bevorzugt Stellen zum Schreiben neuer Daten, die bisher unbeschrieben waren, um den Nachteil der endlichen Schreibmöglichkeiten der Flash-Speicher zu kompensieren. Dies führt zu einer reduzierten Effektivität von Speicherlöschungen durch ein Überschreiben. Teilweise existieren Bereiche auf dem Datenspeicher, welche zu Optimierungszwecken nur dem Controller des Datenspeichers zur Verfügung stehen und dem Nutzer unzugänglich sind. Dies führt dazu, dass die einzige bisher bekannte oder diskutierte Möglichkeit zum analogen Säubern von elektronischen Speichern eine mechanische Zerkleinerung des Datenspeichers ist.

Die US Patentanmeldung US-A-439349 offenbart ein Verfahren zur Löschung eines nichtflüchtigen Speichers mit ionisierender Strahlung, wobei die Speicherzellen vor der Löschung auf ein einheitliches Potential programmiert werden. So wird ein möglichst gleichmässiges Potential nach dem Löschvorgang erreicht, was die Wiederprogrammierung unterstützt. Eine dauerhafte Zerstörung des nichtflüchtigen Speichers durch den Löschvorgang ist nicht vorgesehen.

Wünschenswert wäre eine Möglichkeit, elektronische Speichermedien möglichst effektiv, d.h. zuverlässig und unaufwändig, von sensiblen Daten dauerhaft zu reinigen.

Ausgehend von dem vorliegenden Stand der Technik besteht die Aufgabe der vorliegenden Erfindung darin, ein Verfahren und eine Vorrichtung zur vollständigen und dauerhaften Vernichtung von auf elektronischen Datenspeichern gespeicherten Informationen zu schaffen.

Diese Aufgabe wird durch Verfahren gemäß dem Verfahrensanspruch 1 sowie einer Vorrichtung gemäß Anspruch 11 gelöst.

Eine Erkenntnis der vorliegenden Erfindung besteht darin, dass auf einem Halbleiterbaustein bzw. Datenträger in nicht flüchtigen Speicherelementen gespeicherte Informationen (bspw. gespeicherte logische Zustände) vollständig und dauerhaft gelöscht bzw. vernichtet werden können, indem der mit den Speicherelementen versehene Halbleiterbaustein solange (direkt oder indirekt) ionisierender Löschstrahlung exponiert wird, bis der Halbleiterbaustein eine Solldosis der Löschstrahlung absorbiert hat, wobei bei Erreichen der Solldosis durch die einwirkende ionisierende Löschstrahlung bewirkt wird, dass die Konzentration (bzw. Verteilung oder Dichte) der in den Speicherelementen gespeicherten Ladungsträger derart beeinflusst bzw. geändert wird, dass die nach dem Löschvorgang erhaltene Konzentration von in den Speicherelementen gespeicherten Ladungsträgern unabhängig von dem Ausgangszustand vor dem Löschvorgang ist. Durch Bestrahlen eines Datenspeichers mit einer Löschstrahlung ist eine Konzentration auf den Speicherelementen des Datenträgers gespeicherter Ladungsträger derart beeinflussbar, dass die statistische Verteilung der Schwellenspannungen der Speicherelemente nach der Bestrahlung einen zusammenhängenden Bereich bildet und Daten oder Informationen so sicher gelöscht sind.

Ausführungsbeispiele zeigen ein Verfahren zum Löschen von Informationen, die auf einem elektronischen Halbleiterbaustein in einer Vielzahl von nicht flüchtigen Speicherelementen gespeichert sind, Durch Bestrahlen des Halbleiterbausteins mit einer Löschstrahlung, die den Halbleiterbaustein durchdringt, tritt ein Ionisationseffekt innerhalb des Halbleiterbausteins auf, welcher die Konzentration auf den Speicherelementen gespeicherter Ladungsträger beeinflusst. Durch Aufrechterhaltung der Bestrahlung, bis die Solldosis der Löschstrahlung von dem Halbleiterbaustein absorbiert ist, wird die statistische Verteilung der Schwellenspannungen der Speicherelemente derart beeinflusst, dass die statistische Verteilung einen zusammenhängenden Bereich bildet.

Vorteilhaft an dieser Ausführungsform ist, dass die Speicherelemente durch den zusammenhängenden statistischen der Verteilung der Schwellenspannungen Bereich einen einheitlichen logischen Zustand aufweisen, der unabhängig von einem logischen Zustand der Speicherelemente vor dem Bestrahlen ist.

Ein weiteres Ausführungsbeispiel zeigt ein Verfahren zum Löschen von Informationen, die auf einem elektronischen Halbleiterbaustein in einer Vielzahl von nicht flüchtigen Speicherelementen gespeichert sind. Speicherzustände der jeweiligen Speicherelemente werden während einem Bestrahlen des Halbleiterbausteins mit einer Löschstrahlung derart beeinflusst, dass der jeweilige Speicherzustand nach dem Bestrahlungsvorgang unabhängig von dem Speicherzustand vor dem Bestrahlungsvorgang ist. Vorteilhaft an dieser Ausführungsform ist, dass auch sogenannte Multistate-Speicherzellen, deren Speicherzustände durch mehr als ein Bit repräsentiert werden können, unabhängig von einem Ausgangszustand in einen einheitlichen Zustand überführt werden können.

Ein weiteres Aüsfuhrungsbeispiel der vorliegenden Erfindung zeigt eine Vorrichtung zum Löschen von Informationen, die auf einem elektronischen Halbleiterbaustein in einer Vielzahl von nicht flüchtigen Speicherelementen gespeichert sind. Die Vorrichtung umfasst eine Bestrahlungseinrichtung, die ausgebildet ist, um den Halbleiterbaustein einer Löschstrahlung auszusetzen, bis eine Solldosis erreicht ist.

Vorteilhaft an dieser Ausführungsform ist, dass die Vorrichtung den Halbleiterbaustein mechanisch insoweit unbeschädigt lässt, dass der Halbleiterbaustein oder ein den Halbleiterbaustein aufweisendes Löschobjekt (Gerät) anschließend identifiziert oder die Anwendung des Verfahrens an dem Gerät verifiziert werden kann, beispielsweise von seinem Besitzer. Alternativ oder zusätzlich kann der Halbleiterbaustein oder das Löschobjekt bzw. das den Halbleiterbaustein aufweisende Gerät in einem verschließbaren oder mit einer Plombe sicherbaren Behälter oder durch eine sonstige Umverpackung vor einem unberechtigten Zugriff durch Dritte geschützt werden.

Im Folgenden wird nun erläuternd auf Eigenschaften von elektronischen Halbleiterspeichern, insbesondere Flash-Speichern eingegangen, wobei ferner die Erkenntnisse und erfindungsgemäßen Schlussfolgerungen der Erfinder unter Berücksichtigung der der vorliegenden Erfindung zugrunde liegenden Aufgabe herausgestellt werden.

Mögliche Ausführungsbeispiele der vorliegenden Erfindung werden nachfolgend Bezug nehmend auf die beiliegenden Zeichnungen näher erläutert. Es zeigen:
- Fig. 1: ein schematisches Ablaufdiagramm eines Verfahren zum Löschen von Informationen auf einem elektronischen Speicher durch eine Bestrahlung;
- Fig. 2: ein schematisches Ablaufdiagramm eines weiteren Verfahrens zum Löschen von Informationen, die auf einem elektronischen Halbleiterbaustein gespeichert sind;
- Fig. 3a: eine schematische Darstellung von statistischen Verteilungen von Schwellwertspannungen einer Vielzahl von Single-Level Cell (SLC)-Speicherelementen;
- Fig. 3b-c: statistische Verteilungen der Speicherelemente ausgehend von Fig. 3a, nachdem die Speicherelemente eine Solldosis absorbiert haben;
- Fig. 4a: die .statistische .Verteilung der unprogrammierten Speicherelemente und der statischen Verteilungen der programmierten Speicherelemente einer Vielzahl von Multi-Level Cell (MLC)-Speicherelementen;
- Fig. 4b-c: statistische Verteilungen der Speicherelemente ausgehend von Fig. 4a, nachdem die Speicherelemente eine Solldosis absorbiert haben;
- Fig. 5a: einen schematischen Aufbau eines Speicherelementes beispielhaft in Form eines Metal Oxide Semiconductor Field Effect Transistor (MOSFET) in einem unprogrammierten Zustand;
- Fig. 5b: die schematische Darstellung des MOSFET analog Fig. 5a in einem programmierten Zustand;
- Fig. 6: einen schematischen graphischen Verlauf mit Spannung-Strom-Kurven einer unprogrammierten und einer programmierten Speicherzelle eines MOSFET;
- Fig. 7: eine schematische Darstellung der Effekte ionisierender Strahlung auf ein Flash-Speicherelement eines Halbleiterbausteins;
- Fig.8: eine Prinzipdarstellung einer Vorrichtung zur automatischen Positionierung eines in einem Behälter angeordneten Halbleiterbausteins;
- Fig. 9: eine schematische Darstellung einer Vorrichtung zum Löschen von Informationen, die auf einem elektronischen Halbleiterbaustein gespeichert sind;
- Fig. 10: eine schematische Aufsicht auf eine alternative Vorrichtung zum Löschen von Informationen auf elektronischen Halbleiterspeichern
- Fig. 11: eine schematische Gegenüberstellung einer Elektronenstrahlung mit einer Strahlungsenergie von 5 MeV und einer Co-60 Strahlung.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Obwohl sich nachfolgende Ausführungsbeispiele und Erläuterungen teilweise auf Speicherelemente mit einem Floating-Gate zum Speichern negativer Ladungsträger beziehen, sind die folgenden Ausführungsbeispiele und Erläuterungen auch auf andere elektronische Speicherelemente, bspw. mit einem Floating-Gate zum Speichern positiver Ladungsträger gleichermaßen anwendbar.

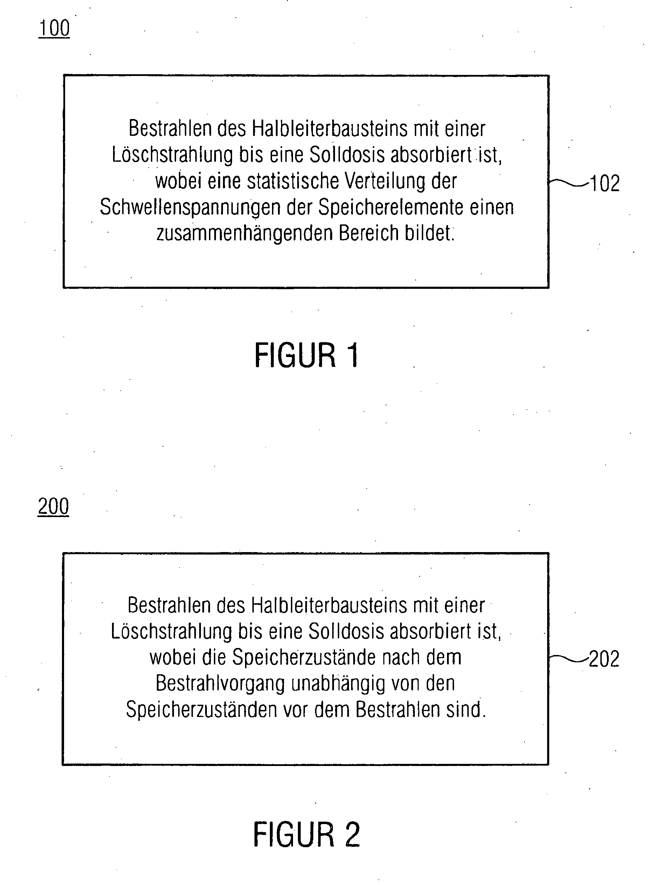

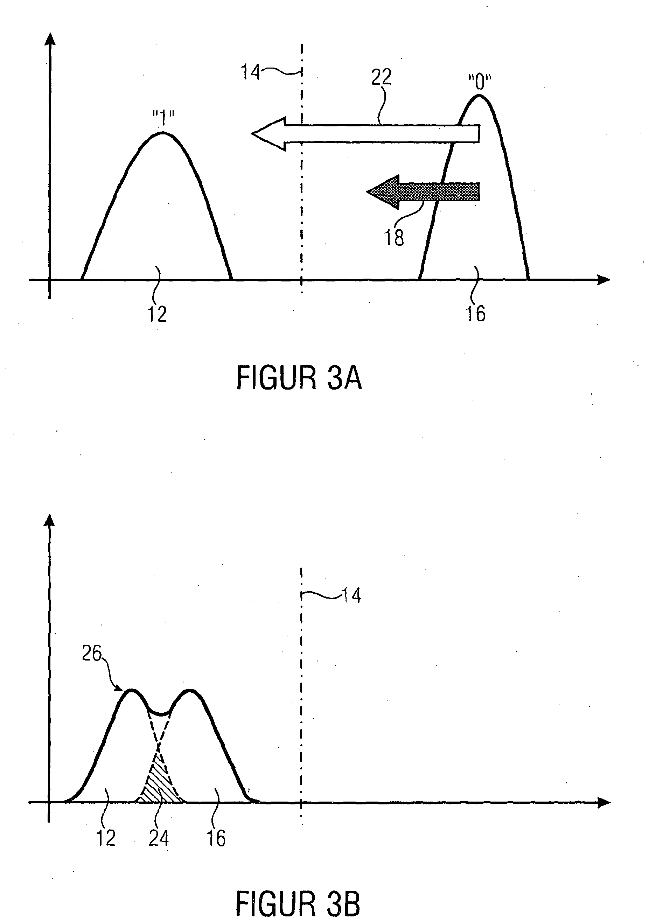

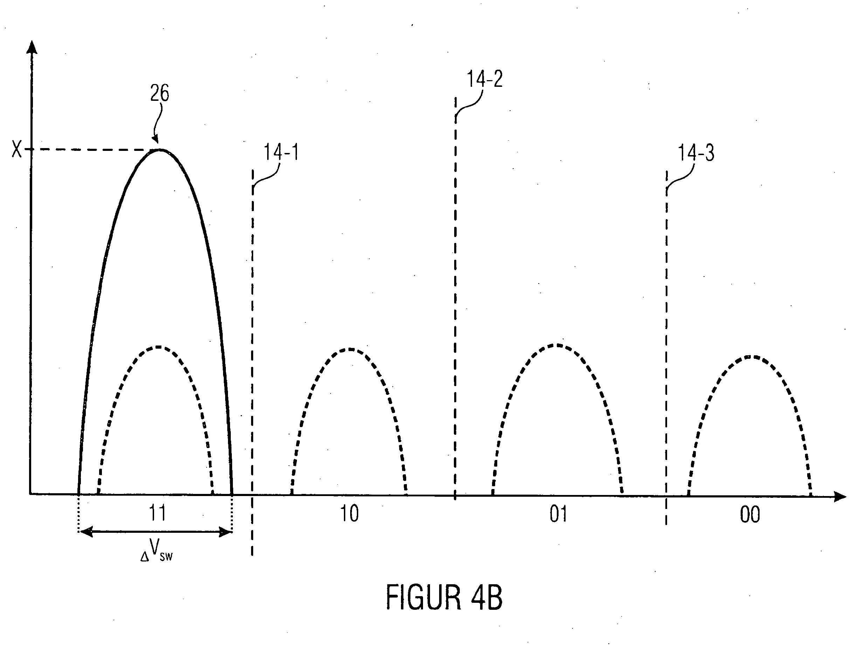

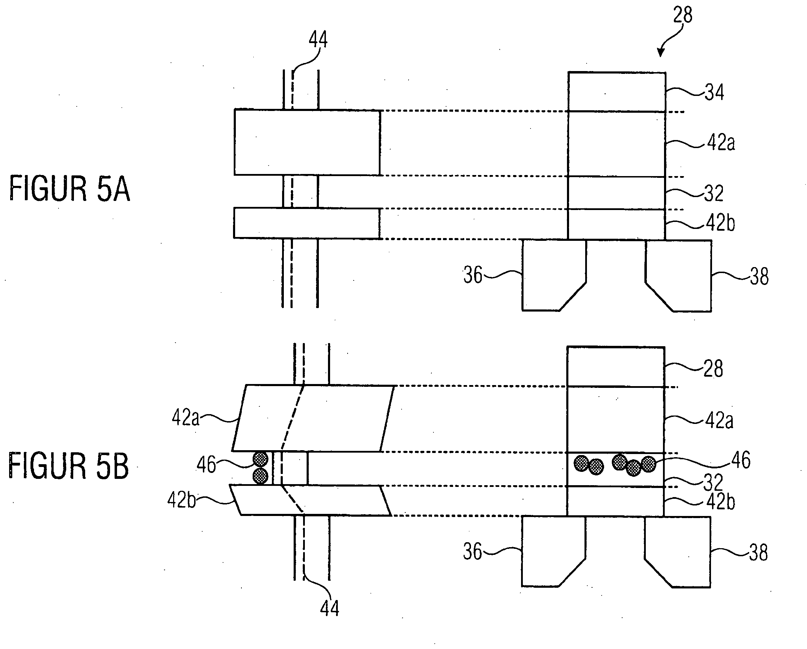

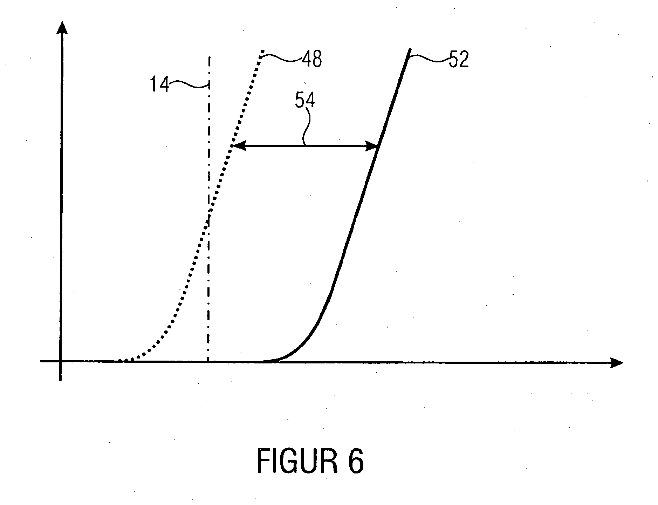

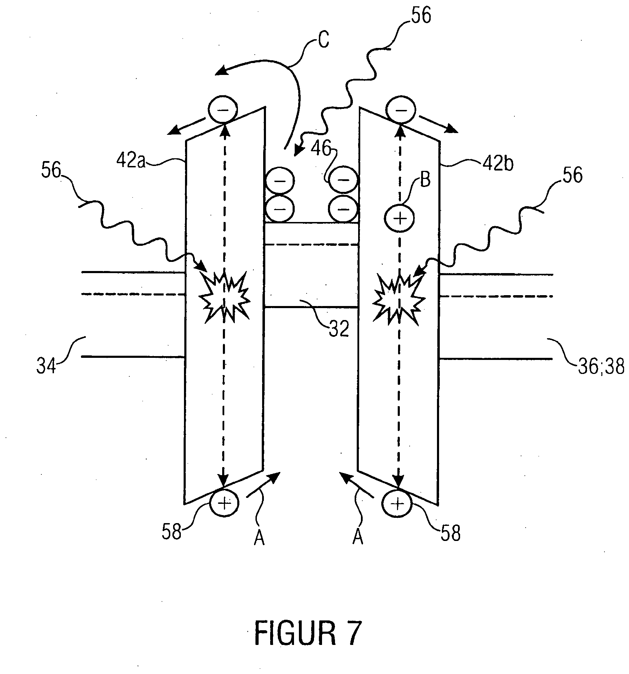

Im Folgenden wird anhand von Fig. 1 ein Verfahren zum Löschen von Informationen, die auf einem elektronischen Halbleiterbaustein in einer Vielzahl von nicht flüchtigen Speicherelementen gespeichert sind, unter Bezugnahme auf die Figuren 3a, 3b, 4b, 5b, 6 und 7 erläutert. Fig. 3a zeigt eine schematische Darstellung von statistischen Verteilungen von Schwellwertspannungen einer Vielzahl von Single-Level-Cell (SLC)-Speicherelementen, Fig. 3b zeigt die statistischen Verteilungen der Speicherelemente analog Fig. 3a, nachdem die Speicherelemente eine Solldosis absorbiert haben. Fig. 4b zeigt die statistische Verteilung der unprogrammierten Speicherelemente und der statischen Verteilungen der programmierten Speicherelemente einer Vielzahl von Multi-Level-Cell (MLC)-Speicherelementen nach der Bestrahlung. Fig. 5b zeigt die schematische Darstellung eines Metal Oxide Semiconductor Field Effect Transistor (MOSFET) in einem programmierten Zustand des Speicherelements. Fig. 6 zeigt einen schematischen Graph mit Spannung-Strom-Kurven einer unprogrammierten (erased) und einer programmierten Speicherzelle eines MOSFET, wobei mit einer programmierten Speicherzelle hier ein Zustand der Speicherzelle gemeint ist, in welchem Ladungsträger auf dem Floating-Gate gespeichert sind. Es kann jedoch auch eine andere Benennung der Zustände der Speicherzellen gewählt werden, insbesondere wenn mehrere verschiedene Konzentrationen von Ladungsträgern voneinander unterschieden werden, wie etwa bei MLC-Speicherelementen. Fig. 7 zeigt eine schematische Darstellung der Effekte ionisierender Strahlung auf ein Flash-Speicherelement eines Halbleiterbausteins.

Fig. 1 zeigt unter Bezugnahme ein Verfahren 100 zum Löschen von Informationen auf einem elektronischen Speicher mit einer Vielzahl von nicht flüchtigen Speicherelementen. Ein Löschen kann beispielsweise ein vollständiges (also 100% der Speicherelemente) oder überwiegendes (bspw. 99,99 %, 99,9999 % oder 99,999999 %) Zurücksetzen der Speicherelemente in einen unprogrammierten Zustand bedeuten, wobei eventuell nicht zurückgesetzte Speicherelemente nicht zusammenhängend auf dem Halbleiterbaustein verteilt sind, sodass einzelne nicht zurückgesetzte Bits keinen Rückschluss auf zuvor gespeicherte Daten oder Informationen erlauben. Der Halbleiterbaustein, bspw. ein Flash-Speicher, ein Field-Programmable-Gate-Array (FPGA) oder ein nicht flüchtiger Speicherbaustein eines Mikrocontrollers, ein Erasable-Programmable-Read-Only-Memory (EPROM) bzw. ein EEPROM, kann Teil einer Speichervorrichtung, bspw. einer SSD, eines USB-Sticks, einer Memory-Card, oder einer Chipkarte sein. Die Speichervorrichtung kann Teil eines Systems, bspw. eines Personal Computer (PC), eines Handys, insbesondere eines Smartphones, eines Tablet-PC's oder eines Notebooks sein. Beschreibungen, die sich nachfolgend auf eine Anordnung von Halbleiterbausteinen beziehen, sind so zu verstehen, dass die Halbleiterbausteine in einer Speichervorrichtung angeordnet sein können und die jeweilige Speichervorrichtung Teil eines Systems sein kann. Ein Löschobjekt bezieht sich auf einen Halbleiterbaustein, der in einer Speichervorrichtung angeordnet sein kann, wobei die Speichervorrichtung in oder ah einem System bzw. Gerät angeordnet sein kann.

In einem Schritt 102 wird ein Halbleiterbaustein mit einer Velzahl von nicht flüchtigen Speicherelementen, die abhängig von einer jeweiligen Realisierung ein oder mehrere Bit an Information repräsentieren, mit einer Löschstrahlung bestrahlt. Auf den Speicherelementen, bspw. Transistoren mit einem Floating-Gate sind die zu Iöschenden Informationen in Form einer Konzentration elektrischer Ladungsträger auf dem Floating-Gates der Speicherelemente gespeichert, wie es beispielsweise in den Figuren 3a und 5b dargestellt ist. Auf einem jeweiligen Floating-Gate werden während eines Programmiervorganges Ladungsträger eingebracht, die dort in einer Konzentration (bzw. Dichte oder Verteilung) vorliegen und den programmierten Zustand repräsentieren. Die Bestrahlung erfolgt, bis die Solldosis der Löschstrahlung von dem Halbleiterbaustein absorbiert ist. Eine Absorption kann abhängig von der Art der verwendeten Löschstrahlung, beispielsweise eine Elektronen- oder eine Protonenstrahlung, ganz oder teilweise durch eine Verlangsamung eines Teilchens der Strahlung nach einer Interaktion, beispielsweise eine Kollision, mit dem Halbleiterbaustein oder einem der Speicherelemente erfolgen. Die Absorption kann alternativ oder zusätzlich, ganz oder teilweise durch eine Neutralisierung des Teilchens der Strahlung innerhalb des Speicherelementes erfolgen. Alternativ oder zusätzlich kann die Absorption ganz oder teilweise auch durch eine Verringerung einer Energie einer Strahlungswelle erfolgen, während die Welle der Löschstrahlung den Halbleiterbaustein durchdringt. Eine Absorption der Löschstrahlung innerhalb des Halbleiterbausteins umfasst beim Verlauf der Strahlung durch den Halbleiterbaustein eine Reduzierung einer Strahlungsintensität und/oder eine Verringerung einer Anzahl von Strahlungsteilchen.

Die Absorption des Anteils der Löshstrahlung führt in dem Halbleiterbaustein zu einem Auftreten eines Ionisationseffektes, der eine Konzentration auf den Speicherelementen gespeicherter Ladungsträger beeinflusst. Die Ladungsträger bzw. die Konzentration der Ladungsträger auf den Speicherelementen definieren einen logischen Zustand des jeweiligen Speicherelements, wie es in den Fig. 3b und 4b gezeigt ist. Der Ionisationseffekt führt beispielsweise zu einer Verringerung von auf einem Floating-Gate gespeicherter elektrischer Ladung durch verschiedene Mechanismen, die im Folgenden anhand von Fig. 7 noch erläutert werden. Eine Reduktion der Konzentration elektrischer Ladungsträger auf dem Floating-Gate eines Speicherelements kann zu einem Abfall einer Schwellenspannung des jeweiligen Speicherelements unterhalb einer Lesespannung führen, wie es anhand der Figuren 3a und 3b dargestellt ist, so dass ein Speicherelement, beispielsweise in einem programmierten Zustand, von einem den Halbleiterbaustein oder die Speichervorrichtung auslesenden Gerät als "unprogrammiert" erkannt wird und kein weiterverarbeitbarer Code ausgelesen oder wiederhergestellt werden kann, da der ursprüngliche Zustand der Speicherelemente nicht wiederhergestellt werden kann.

Das Verfahren 100 erlaubt eine berührungslose und zuverlässige Löschung von Daten oder Informationen, indem die Informationen in Form elektrischer Ladungsträger von den Floating-Gates, die eine entsprechende Programmierung aufweisen, entfernt wird. Der Löschvorgang ist somit irreversibel und dauerhaft, sodass eine zuverlässige Löschung von Daten oder Informationen möglich ist. In anderen Worten beschreibt das hier beschriebene Verfahren 100 ein Verfahren zur dauerhaften Vernichtung von Daten in elektronischen Speichermedien mit nicht flüchtigen Speicherelementen.

Informationen oder sensible Daten auf jeglichen Geräten, die nicht flüchtige Speicherelemente auf Basis von Ladungsspeicherung verwenden, können durch Anwendung des Verfahrens gelöscht werden. Die Halbleiterbausteine, Speichervorrichtungen oder Systeme müssen zu diesem Zweck nicht geöffnet werden. Die Halbleiterbausteine werden möglicherweise : als Teil der jeweiligen Speichervorrichtung oder Systems (die mit den Halbleiterbausteinen versehenen Geräte) der Löschstrahlung, beispielsweise einer ionisierehden Strahlung, exponiert. Als ionisierende Strahlung kann beispielsweise eine Wellenstrahlung, beispielsweise eine Elektronenstrahlung oder eine Photonenstrahlung, oder eine Teilchenstrahlung, beispielsweise eine Protonenstrahlung oder eine Neutronenstrahlung eingesetzt werden. Das Bestrahlen kann alternativ oder zusätzlich mit einer Strahlung mit Schwer-Ionen durchgeführt werden. Die Art und Energie der ionisierenden Strahlung kann so gewählt werden, dass die Speicherelemente, ggf. innerhalb eines Gehäuses einer Speichervorrichtung, der Strahlung exponiert sind, die Speicherelemente von der ionisierenden Strahlung durchdrungen werden und einen Teil der ionisierenden Strahlung absorbieren.

Die ionisierende Strahlung bewirkt aufgrund der nachfolgend in Fig. 7 beschriebenen Ionisationseffekte eine Veränderung der Schwellenspannungen der einzelnen Speicherelemente. Die Veränderung der Schwellenspannung kann durch einen der drei nachfolgend erläuterten Effekte oder eine Kombination dieser Effekte bewirkt werden. Die ionisierende Strahlung bewirkt bei einem ersten, in Fig. 7 als Effekt A bezeichneten, Effekt, dass Ladungen in den das Floating-Gate umgebenden Isolatoren erzeugt, bzw. freigesetzt werden. Diese Ladungen dringen in das Floating-Gate ein und neutralisieren die auf dem Floating-Gate gespeicherte Ladung zumindest teilweise. Ein zweiter bewirkter Effekt B führt dazu, dass Ladung aus dem Floating-Gate in den Isolatoren an durch die ionisierende Strahlung erzeugten Fehlstellen eingefangen, d.h. gebunden wird, und so Ladungsträger auf dem Floating-Gate maskiert. Ein dritter Effekt C ist die Photoemission. Das energetische Niveau der Ladungsträger im Floating-Gate durch die Strahlung derart angehoben, dass die Ladungsträger genug Energie aufweisen, um die Potentialbarriere des das Floating-Gate umgebenden Isolators zu überwinden. Der Effekt B ist im Allgemeinen gering (weniger als 10 %) gegenüber den Effekten A und C.

Zusammenfassend führt ionisierende Strahlung zu einer Entladung des Floating-Gates und damit zu einer Verschiebung der in Fig. 6 dargestellten Kennlinie des resultierenden Drain-Stroms in Abhängigkeit einer angelegten Spannung am Control-Gate. Nach Absorption der Solldosis durch das jeweilige Speicherelement ist die Schwellenspannung des Speicherelementes derart reduziert und mithin die Kennlinie 52 derart weit in Richtung der Kennlinie 48 der Fig. 6 verschoben, dass eine beibehaltene Lesespannung 14 eine ursprünglich programmierte Speicherzelle bzw. ein ursprünglich programmiertes Speicherelement nicht als solches identifiziert. Das Speicherelement wird als unprogrammiert identifiziert.

Über die Summe aller Speicherelemente, die in ihren jeweiligen Zuständen einer statistisehen Verteilung unterliegen, bilden die statistischen Verteilungen 12 und 16 Bereiche bezüglich der Schwellenspannungen der Speicherelemente, wie es in Fig. 3a und 3b erläutert ist. Eine Entladung der Floating-Gates, bzw. ein Angleichen der Ladungszustände (bzw. Ladungsdichte) der Floating-Gates führt zu einer Annäherung der statistischen Bereiche 12 und 16. Nach Absorption der Solldosis bilden die Bereiche der statistischen Verteilungen 12 und 16 einen gemeinsamen Bereich 26. Innerhalb des gemeinsamen Bereichs 26 ist keine Lesespannung definierbar, die eine fehlerfreie Unterscheidung von programmierten und unprogrammierten Speicherelementen und damit deren ursprünglichen logischen Zustände ermöglicht. Die statistischen Verteilungen 12 und 16 können bspw. durch kleine Schwankungen der Prozesse bei der Chipherstellung verursacht sein. Dies kann zu einer Varianz der Schwellenspannungen führen. Die Schwellenspannungen der Speicherelemente können somit von den Ladungsträgern auf dem Floating-Gate und/oder von Varianzen beeinflusst sein. Speicherzellen, bzw. Speicherelemente, deren Schwellenspannung die Lesespannung unterschreitet, werden bei einer Single-Level-Cell (SLC) bspw. als binärer Zustand 1, d.h. unprogrammiert, interpretiert. Werden mit steigender, durch die Speicherbausteine absorbierter Strahlungsdosis zunehmend Ladungsträger vom Floating-Gate des Speicherbausteins entfernt oder neutralisiert, so dass eine Konzentration der Ladungsträger auf dem Floating-Gate sinkt, wobei die statistische Verteilung ursprünglich programmierter Zellen in Richtung der statistischen Verteilung der Zellen im unprogrammierten Zustand wandert. Nach Absorption der Solldosis der Strahlung liegen die Speicherelemente in einem neutralen Zustand vor. Damit kann eine analoge Säuberung erreicht werden, die einer Analogie zum Degaussen bei magnetischen Festplatten entspricht.

Nach Absorption der Solldosis liegen sowohl die ursprünglich programmierten als auch die ursprünglich unprogrammierten Speicherelemente unabhängig von ihrem jeweiligen Ausgangzustand im unprogrammierten Zustand vor. Eine Abhängigkeit von einem Ausgangszustand der Speicherelemente ist damit aufgehoben.

Die verwendete Strahlung muss eine gewisse (d. h. ausreichende) Energie besitzen, um den Datenträger vollständig durchdringen zu können, um so das Bestrahlen jeder Speicherzelle bzw. jedes Speicherelements zu gewährleisten. Eine vollständige Durchdringung bedeutet, dass alle Bereiche räumlich durchstrahlt (d.h. alle Bereiche vollständig bzw. gleichmäßig durchdrungen werden und ein ausreichend hoher Anteil (bspw. 99 % oder 99,999 %) der Speicherelemente, im Idealfall alle (100%), dem Ionisationseffekt ausgesetzt sind, so dass nach Absorption der Solldosis die Konzentration von gespeicherten Ladungsträgern derart beeinflusst wird, dass die statistische Verteilung der Schwellenspannungen der Speicherelemente einen zusammenhängenden Bereich bildet. Das bedeutet, dass die Konzentration von Ladungsträgern nach dem Bestrahlungsvorgang unabhängig von der Konzentration von Ladungsträgern vor dem Besfrahlungsvorgang ist, so dass der ursprüngliche logische Zustand der Speicherelemente nicht mehr ermittelbar ist. Ein verbleibender Anteil von Speicherelementen (bspw. ein Anteil von weniger als 1 % oder weniger als 0,001 %), die dem Ionisationseffekt nicht oder nicht ausreichend ausgesetzt sind, sind im Allgemeinen auf dem Halbleiterbaustein derart verteilt, dass keine relevanten Fragmente von auf dem Halbleiterspeicher gespeicherten Informationen wiederhergestellt werden können. Zur Definition der Solldosis kann bspw. eine von dem Halbleiterbaustein zu absorbierende Energie der Strahlung definiert werden, die zu einer möglicherweise vollständigen Durchdringung des Halbleiterbausteins führt.

Die Solldosis oder Mihdestdosis kann dabei abhängig von dem zu löschenden Löschöbjekt oder dem Halbleiterbaustein bestimmt werden. Eine Bestimmung der Solldosis kann alternativ oder zusätzlich von der Dichte oder den Materialien des Halbleiterbausteins, der Speichervorrichtung oder des Systems erfolgen. Ausführungsbeispiele zeigen Löschverfahren mit einer Solldosis von 1 kGy für zu löschende Speichervorrichtungen. .Alternative Ausführungsbeispiele zeigen eine Solldosis von 5 bis 8 kGy. Weitere Ausführungsbeispiele zeigen eine Solldosis von 10 kGy.

Alternativ oder zusätzlich kann eine Bestrahlungszeit abhängig von einer Strählungsquelle der ionisierenden Strahlung bestimmt werden. Für eine Strahlungsleistung der Strahlungsquelle,bspw 6 kGy/h und eine Energie der von der Strahlungsquelle emittierten Strahlung ergibt sich bei einem Halbleiterbaustein eine . Solldosis, bspw. 2 kGy. Daraus kann eine Bestrahlungszeit, bspw. 2 kGy / (6 kGy/h) = 0,3 h = 18 min, bestimmt werden. Ein vergrößertes zu bestrahlendes (sensitives) Volumen, d. h. Volumen; welches bestrahlt wird, um die Solldosis zu absorbieren, beispielsweise aufgrund eines größeren Halbleiterbausteins oder mehrerer gleichzeitig bestrahlter Halbleiterbausteine oder Geräte, kann zu einer geringeren Energie und mithin Strahlungsleistung bezüglich des bestrahlten Volumens führen, woraus eine verlängerte Bestrahlungsdauer resultieren kann.

Das Verfahren 100 kann unabhängig von einer Festlegung Weiterer Anwendungsparameter wie beispielsweise einer Dosisleistung oder einer Temperatur angewendet werden.

Das Verfahren 100kann dabei derart ausgeführt werden, dass Geräte und/oder Halbleiterbausteine einer kontinuierlichen Strahlung ausgesetzt werden, bis die Solldosis erreicht ist. In alternativen Ausführungsbeispielen erfolgt die Bestrahlung in mehreren Schritten, wobei die Intensität oder die Dauer der Schritte variieren kann. . Es kann erforderlich sein, die Solldosis bspw. für unterschiedliche "Klassen" von Löschobjekten, wie etwa Tablet-PCs oder externe Speichermedien, experimentell oder durch Simulation zu bestimmen. In einer experimentellen Bestimmung können beispielsweise mehrere Löschobjekte,für die die Solldosis bestimmt werden soll, unterschiedlichen (vorgegebenen) Strahlungsdosen ausgesetzt werden. Im Anschluss an die Bestrahlung kann eine Auswertung, ggf eine forensische Analyse, erfolgen, um den jeweiligen Löschzustand eines Löschöbjekts in Abhängigkeit der absorbierten Strahlungsdosis zu bestimmen.

Bei einem konkreten Beispiel können bspw. insgesamt N (mit N = 100) Secure Digital (SD) Memory Karten (SD-Karten) einer ionisierenden Strahlung ausgesetzt werden, bis eine Dosis von 0,2, 2, 20 bzw. 200 kGy von jeweils N/4 (25) SD-Karten absorbiert ist. In einer anschließenden forensischen Untersuchung kann feststellbar sein, dass SD-Karten, die eine Dosis 0,2 kGy absorbiert haben, noch immer mit einem Standardinterface, wie einem SD-Kartenleser in einem PC, ausgelesen werden können. Ferner kann feststellbar sein, dass SD-Karten, die eine Dosis von 2 kGy absorbiert haben nur mit erhöhtem Aufwand unter Umgehung von Standard-Interfaces auslesbar sind, was mit einer digitalen Säuberung von magnetischen Festplatten vergleichbar sein kann. Weiterhin kann feststellbar sein, dass SD-Karten,die eine Dosis von 20 kGy absorbiert haben, keine oder lediglich minimale Restladungen auf den jeweiligen Floating-Gates der der Speicherbausteine der SD-Karten aufweisen und Karten, die eine Dosis von 200 kGy absorbiert haben, zusätzlich eine farbliche (physikalische oder chemische) Veränderung der Kunststoffteile der SD-Karten aufweisen und Elektronikkomponenten zerstört sind, sodass die SD-Karten inoperabel sind und keine reproduzierbaren Schreib- und/oder Lesezugriffe ausführbar sind. Eine Zerstörung der Elektronikkomponenten kann durch eine Veränderung von Isolationsstrukturen der Bauelemente hervorgerufen werden; die zumindest teilweise eine elektronisch isolierende Eigenschaft verlieren, sodass .die Funktionalität der Elektronikkomponenten zumindest teilweise aufgehoben ist.

Aus einer solchen exemplarischen Versuchsreihe kann beispielsweise abgeleitet werden, dass basierend auf den Ergebnissen für die Dosis von 2 kGy, beaufschlagt mit einem Sicherheitsfaktor von 1,5eine Solldosis von 3 kGy eine zuverlässige digitale Säuberung ermöglicht. Ferner kann beispielsweise abgeleitet werden, dass eine Dosis von 10 kGy eine für eine analoge Säuberung hinreichende Löschung der auf den SD-Karten gespeicherten Informationen oder Daten erlaubt, da die Hälfte der Dosis von 20 kGy (siehe oben), bewirkt, dass nur so viele Ladungsträger auf den Floating-Gates der SD-Karten verbleiben, dass eine Widerherstellung der ursprünglichen Daten oder Informationen verhindert ist. Die Solldosis für die SD-Karten des untersuchten Typs kann unter den obigen exemplarischen Annahmen und Ergebnissen mit 10 kGy durch Interpolation der Ergebnisse für absorbierte Dosen von 2 kGy und 20 kGy bestimmbar sein. Alternative Ausführungsbeispiele zeigen eine Bestimmung der Solldosis mit einem Wert von 20 kGy für obige SD-Karten, da nach Absorption dieser Dosis durch die SD-Karten eine nahezu vollständige Entfernung von auf dem Floating-Gate gespeicherten Ladungsträgern erfolgt.

Die Solldosis kann auch so gewählt werden, dass der Halbleiterbaustein nach Absorption der Solldosis inoperabel ist, d. h. es müssen chemische oder physikalische Veränderungen in dem Halbleiterbaustein erfolgt sein, die reproduzierbare Schreib- und/oder Lesevorgänge unterbinden. Dies entspricht in obigem Beispiel einer absorbierten Dosis von 200kGy.

Zusammenfassend kann also festgestellt werden, dass Solldosen durch experimentelle Versuche und anschließende forensische Untersuchungen bestimmt werden können, wobei die experimentellen Ergebnisse mittels Interpolationsschritten ableitbar sind und mit Sicherheitsfaktoren beaufschlagt werden können.

Die Solldosis kann auch mittels Simulationen ermittelt werden, indem die Absorption einer Strahlungsdosis durch ein Löschobjekt anhand von Simulationen durchgeführt werden, bspw. in einem Simulationsprogramm. Insbesondere können sich Simulationen auf vergangene experimentelle Bestimmungen stützen. Beispielsweise kann ein neuer Typ von SD-Karten, möglicherweise mit einem neu produzierten Typ von Halbleiterbaustein auf Ähnlichkeiten mit bereits untersuchten Halbleiterbausteinen untersucht werden, sodass: eine Berechnung einer Solldosis basierend auf Simulationen und/oder experimentellen Versuchs- und/oder Berechnungsergebnissen erfolgen kann.

Es sei angemerkt, dass die obigen Beispiel lediglich möglidhe Ausführungsformen der experimentellen oder simulierten Bestimmung einer Solldosis für einen Typ von Löschobjekten ist.

Innerhalb eines Bestrahlungsschrittes bewirkt die ionisierende Strahlung eine möglicherweise kontinuierliche Verringerung der auf dem Floating-Gate gespeicherten Ladung. Nach Absorption der Solldosis sind derart wenige oder keine gespeicherten Ladungen in den Speicherzellen, bzw. den Speicherelementen vorhanden, womit die Information gelöscht ist.

Durch Verwenden einer ionisierenden Strahlung ermöglicht das Verfahren 100, dass der Halbleiterbaustein, das Gerät oder das System während der Bestrahlung oder während der gesamten Datenvernichtungsaktion in einer Umverpackung (bspw. einem Behälter oder einem Gehäuse) angeordnet ist, die beispielsweise verplombt oder andersartig gesichert ist. Innerhalb der Umverpackung können aufgrund der Durchdringung durch die Strahlung ein oder mehrere Speicherbausteine, Speichervorrichtungen oder Systeme angeordnet werden.

Die Umverpackung wird während des Bestrahlens ebenfalls von der Strahlung durchdrungen. Dabei kann ein gewisser Anteil der Strahlung von dem Gehäuse absorbiert werden. Ein von dem Gehäuse absorbierter Strahlungsanteil kann bezüglich der Bestimmung der Solldosis unter Bezugnahme auf die jeweilige Strahlungsquelle berücksichtigt werden, indem beispielsweise die Bestrahlungsdauer erhöht wird.

Da während des Bestrahlens kein physikalischer oder mechanischer Zugriff auf die Datenträger bzw. die Halbleiterbausteine nötig ist, kann eine Datenvernichtung in einer verschlossenen, beispielsweise verplombten Umverpackung oder Behältnis erfolgen, wohingegen während einer mechanischen Zerkleinerung jeder Datenträger von Personen und/oder Automaten der Vernichtung zugeführt werden muss. Dies bedingt eine vertrauensvolle Zusammenarbeit mit einem entsprechenden, das Verfahren ausführenden Dienstleister, da insbesondere Personen Datenträger missbräuchlich auswerten oder einen unberechtigt auf die Datenträger und / oder darauf gespeicherte Dateien oder Informationen zugreifen können. Durch eine verschlossene Umverpackung kann dies verhindert werden bzw. ein unbefugter Zugriff durch eine Beschädigung des Verschlusses oder der Umverpackung festgestellt werden.

Generell kann ionisierende Strahlung Informationen auf elektronischen Speichermedien beeinflussen. Je nach Speichertyp, das bedeutet Art des zu bestrahlenden Halbleiterbausteins und verwendeter Strahlungsart sowie -menge, bzw.-dosis sind nach der Bestrahlung Teile des Speichers sowie die gesamten Informationen so verändert, dass ein Wiederherstellen der ursprünglichen Daten aufgrund fehlender Abhängigkeiten der Speicherzustände und/oder fehlerhaften Halbleiterelementen der Speicherelemente verhindert wird. Damit beschreibt das Verfahren ein vollständiges und dauerhaftes Vernichten von Informationen in elektronischen Speichermedien durch eine Verwendung von ionisierender Strahlung. Der Datenträger bzw. der Halbleiterbaustein mit den zu vernichtenden Informationen wird einer ausreichenden Menge von Strahlung ausgesetzt, bis die Solldosis von dem Halbleiterbaustein absorbiert ist.

Eine mechanische Zerkleinerung kann dazu führen, dass eine Identität des Dataspeichers oder des Geräts bspw aufgrund zu kleiner Partikel oder einer Vermischung von Partikeln verschiedener Geräte möglicherweise technisch nicht nachgewiesen werden : kann. Da dagegen der Halbleiterbaustein, die Speichervorrichtung oder das System nach der Datenvernichtung mit dem Verfahren 100 mechanisch in Takt ist, ist eine Verifizierung oder eine Identifizierung des Halbleiterbausteins, beispielsweise durch den Kunden oder Besitzer, möglich. Eine sichere Vernichtung der Daten kann ferner unabhängig von mechanischen Prozessparametern, wie beispielsweise einer durch das mechanische Zerkleinern bestimmten Partikelgröße gewährleistet werden. Ein mechanisches Zerkleinern erfordert bei steigenden Dichten von Speicherelementen auf dem Halbleiterbaustein, das bedeutet steigende Speicherdichten, sinkende und kleinere Partikelgrößen, um eine Anzahl von Speicherelementen und mithin den Umfang vorhandener Daten pro Partikel konstant zu halten oder zu verringern. Die mechanische Zerkleinerung von Halbleiterbausteinen kann zu vermischten Partikeln verschiedener Materialien und somit Rest- oder Sondermüll,der mit Gefahrstoffen und Wertstoffen durchsetzt sein kann, führen. Demgegenüber erlaubt ein durch Bestrahlung gelöschter Datenträger eine weitere Verwertung, beispielsweise ein Recycling, da ein Großteil des Datenträgers mechanisch intakt verbleibt und bspw. demontiert und nach Materialien separiert werden kann.

Insgesamt erlaubt eine Datenvernichtungdurch eine Bestrahlung mit dem Verfahren 100 ein Löschen von Informationen mit deutlich geringerem Risiko eines Fehlverhaltens einzelner Personen. Obwohl die Systeme, Speichervorrichtungen oder Halbleiterbausteine nach dem Bestrahlen weitestgehend mechanisch intakt sind, kann das Verfahren 100 einige typische und irreversible mechanische oder optische Veränderungen bewirken, beispielsweise bei den in den Geräten oder Halbleiterbausteinen verwendeten Kunststoffen. Je nach chemischer Zusammensetzung der Kunststoffe können Kunststoffe spröde oder weich werden oder Verfärbungen aufweisen. Diese Veränderung kann bei einer nachträglichen forensischen Analyse, beispielsweise einer Verifikation des Verfahrens 100, festgestellt werden. Neben dem Zustand der vernichteten Daten können durch die Bestrahlung entstehende Strahlenschäden an den bestrahlten Elementen, bspw. in den Halbleiterbausteinen, Isolatoren oder Kunststoffen, charakteristische Spuren liefern, die die Anwendung des Verfahrens 100 retrospektiv nachweisen. Alternativ oder zusätzlich können optische Veränderungen, beispielsweise bei Gläsern oder durchsichtigen Polymeren festgestellt werden, beispielsweise indem durchsichtige Elemente durch die Bestrahlung erst dunkler und schließlich ganz undurchsichtig werden können.

Bestrahlte elektronische oder optische Komponenten, beispielsweise Halbleiterelemente, Linsen in Kameras oder Displays, werden durch das Verfahren 100 möglicherweise irreparabel geschädigt. Dies erhöht die Sicherheit der Datenvernichtung und verhindert eine Verwendung der Geräte nach der Datenvernichtung,beispielsweise durch ein unerlaubtes Entwenden der gelöschten Geräte oder Speicher. Die Beschädigung der elektronischen Komponenten resultiert aus einer starken Erhöhung von Leckströmen in elektrischen Komponenten, welche Isolatoren verwenden. . Zusätzlich können Kennlinien von Halbleiterelementen durch in Isolatoren generierten und gespeicherten Ladungen verschöben werden. Derartige Veränderungen können in Form von charakteristischen Spuren erkannt und deutlich von Alterungserscheinungen unterschieden werden. Die Erkennung der charakteristischen Spuren ermöglicht eine Verifikation des Löschverfahrens 100.

Gemeinsam mit dem Halbleiterbaustein, der Speichervorrichtung oder dem System kann ein Indikatorelement, beispielsweise in Form eines Plättchens, eines Röhrchens, Stäbchens, Zylinders oder eines Würfels, bestrahlt werden, das bei Erreichen der Solldosis eine physikalische oder chemische Eigenschaft verändert. Eine sich ändernde physikalische Eigenschaft kann beispielsweise eine Zähigkeit oder eine Festigkeit des Glases oder des Polymeres oder eine Transparenz des Werkstoffes sein. Eine sich ändernde chemische Eigenschaft kann bspw. eine Farbe eines Papiers des Indikatorelementes sein. Das Indikatorelement kann beispielsweise an oder in einer entsprechenden Umverpackung oder Behältnis angeordnet sein und ganz oder teilweise aus Glas oder einem polymeren Werkstoff gebildet sein. Die Polymerwerkstoffe können ganz oder teilweise transparent oder opak sein.

Das Vernichten der Daten kann durch die Bestrahlung schnell und günstig erfolgen, da große Mengen von Datenträgern gleichzeitig bestrahlt werden können. Die Anwendung des Verfahrens ist überprüfbar, da ein Auftraggeber den oder die Datenträger nach erfolgter Bestrahlung zurück erhalten kann. Ferner kann eine Anwendung des Verfahrens 100 transparent ausgestaltet werden, indem Details des Verfahrens bekanntgegeben werden. Zusätzlich kann Verfahren 100 mit geringerem Risiko durch nicht vertrauenswürdiges. Personal ausgeführt werden, da das Verfahren 100 eine komplette Logistikkette mit verplombten Umverpackungen ermöglicht.

In Ausführungsbeispielen erfolgt die Bestrahlung derart, dass die ein oder mehrere Halbleiterbausteine Speichervorrichtungen und/oder Systeme aus verschiedenen Winkeln bestrahlt werden, bis die Solldosis von den Halbleiterbausteinen absorbiert ist. Der bzw die Halbleiterbausteine können an einer stationären Strahlungsquelle durch eine Transporteinrichtung, beispielsweise auf einem Fließband, vorbeigeführt werden. Alternativ oder zusätzlich können der oder die Halbleiterbausteine, beispielsweise von einer verplombten Umverpackung umschlossen, vor der stationären Strahlungsquelle gedreht werden, um eine Bestrahlung des oder der Halbleiterbausteine von mehreren Seiten zu ermöglichen. Dies ermöglicht eine Verringerung von eventuellen Intensitätsschwankungen innerhalb des bestrahlten Bereiches, die beispielsweise durch Strahlungsabsorption in: den Halbleiterbausteinen verursacht werden kann.

Der Halbleiterbaustein bzw. die Halbleiterbausteins können relativ zu der Strählungsqüelle in einen und/oder durch einen Bestrahlungsbereich mit einer Transportgeschwindigkeit bewegt und während der Bewegung der Bestrahlung ausgesetzt werden. Die Transportgeschwindigkeit kann an die Solldosis, die von den Halbleiterbausteinen absorbiert wird, angepasst sein. Eine reduzierte Transportgeschwindigkeit kann gegenüber einer höheren Transportgeschwindigkeit zu einer langsameren Durchquerung des Bestrahlungsbereiches und einer höheren absorbierten Strahlungsdosis führen. Dies ermöglicht einen kontinuierlichen Transport der Halbleiterbausteine. Alternativ oder zusätzlich kann der Halbleiterbaustein bzw. die Halbleiterbausteine in den Bestrahlungsbereich hineinbewegt und dort abgelegt werden und nach Absorption der Solldosis aus dem Bestrahlungsbereich herausbewegt werden. ("Stop and Go"-Betrieb). Sowohl im "Stop and Go"-Betrieb als auch bei einer Bewegung der Halbleiterbausteine mit der Relativbewegung können die Halbleiterbausteine oder die Behälter, in denen die Halbleiterbausteine angeordnet sind, ein- oder mehrmals, ggf kontinuierlich bezüglich der Strahlungsquelle gedreht werden, um in unterschiedlichen Winkeln mit der ionisierenden Strahlung bestrahlt zu werden.

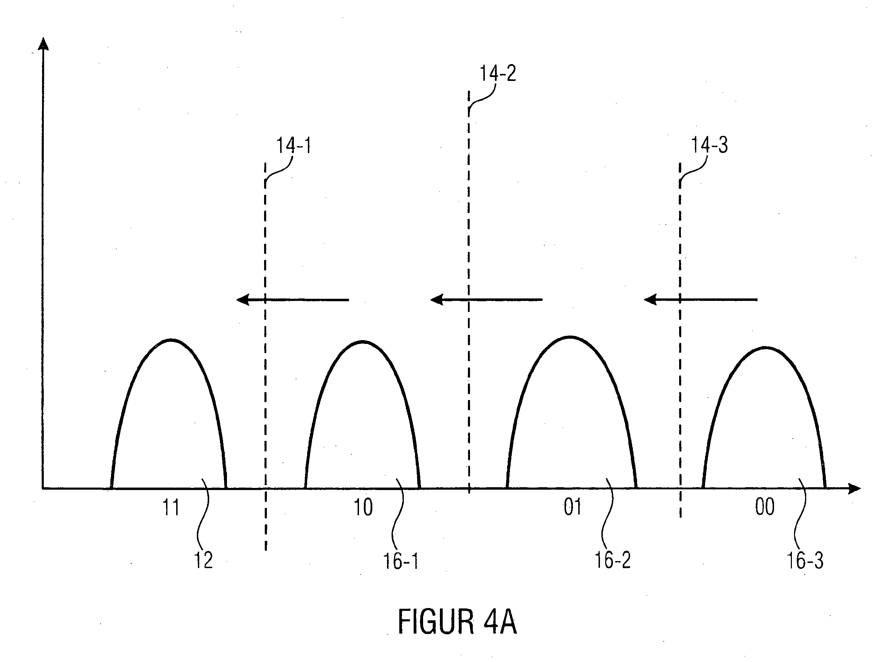

Fig. 2 zeigt unter Bezugnahme auf Fig. 4a und Fig. 4b ein schematisches Ablaufdiagramm eines Verfahrens 200 zum Löschen von Informationen, die auf einem elektronischen Halbleiterbaustein in einer Vielzahl von nicht flüchtigen Speicherelementen jeweils als Speicherzustand gespeichert sind. Ein Speicherzustand umfasst beispielsweise in einer SLC die Unterscheidung eines Zustands eines Bits in Null und Eins. Im Falle einer Multi-Level Cell (MLC) können in einem Speicherelement auch mehrere, beispielsweise vier, Speicherzustände realisiert sein, die als vier logische Zustände, bspw. eine Bitkombination von "00", "01", "10" und "11" interpretiert werden können.

Fig. 4a zeigt beispielhaft eine schematische Darstellung statistischer Verteilungen von Speicherelementen eines Halbleiterbausteins mit MLCs, deren jeweiliger Speicherzustand zwei Bit und somit vier Zustände repräsentiert. Fig. 4b zeigt schematisch die statistische Verteilung der Speicherelemente nach der Bestrahlung gemäß dem Schritt 102 oder einem Schritt 202.

In dem Schritt 202 wird der Halbleiterbaustein mit einer Löschstrählung bestrahlt, bis die Solldosis von dem Halbleiterbaustein - absorbiert ist. Die Löschstrahlung durchdringt den Halbleiterbaustein während der Bestrahlung derart, dass zumindest ein Teil der Löschstrahlung in dem Halbleiterbaustein absorbiert wird. Das Absorbieren des Teils der Löschstrahlung führt zu einem Auftreten eines Ionisafibnseffektes in dem Halbleiterbaustein bzw. in den Speicherelementen. Der Ionisationseffekt führt dazu, dass die Speicherzustände der Speicherelemente derart beeinflusst werden, dass die Speicherzustände. nach dem Bestrahlungsvorgang unabhängig von den Speicherzuständen vor dem Bestrahlungsvorgang sind, sobald die Solldosis absorbiert ist.

Das Verfahren beschreibt ein Verfahren zur vollständigen und dauerhaften Vernichtung von auf Datenträgern gespeicherten Informationen mittels direkt oder indirekt ionisierender Strahlung. Das Verfahren kann bestehende, langjährig etablierte Infrastrukturen bestehender Unternehmen, die möglicherweise derzeit andere Methoden verwenden, nahtlos nutzen Dazu gehören als sicher zertifizierte Logistikketten von einem Kunden zur Vernichtungsstätte, Kundenbeziehungen zu Behörden, Institutionen und Unternehmen und gängige Verifikationsverfahren zur Wirksamkeitsprüfung. Insgesamt kann das Verfahren weltweit Anwendung finden, insbesondere dort, wo Informationen auf Datenträgern vernichtet werden sollen.

Die Verfahren 100 und 200 sind grundsätzlich für alle Floating-Gate basierten Speichertechnologien einsetzbar, wobei die jeweiligen . Erläuterungen untereinander anwendbar und austauschbar sind.

Fig. 3a zeigt eine schematische Darstellung von statistischen Verteilungen von Schwellwertspannungen einer Vielzahl von SLC-Speicherelementen. Auf einer Abszisse ist aufsteigend die Schwellwertspannung an einem Control-Gate des entsprechenden Speicherelements dargestellt. Die Ordinate zeigt qualitativ eine Anzahl von Speicherelementen, die eine an der Abszisse angegebene Schwellwertspannung umfassen. Speicherelemente in einem unprogrammierten Zustand werden nachfolgend mit dem binären Zustand 1 bezeichnet, wohingegen Speicherelemente in einem programmierten Zustand mit dem binären Zustand 0 bezeichnet werden. Die binäre Bezeichnung der Speicherelemente kann auch in einer alternativen Weise erfolgen, bspw. mit dem Zustand 1 für programmierte und mit dem Zustand 0 für unprogrammierte Speicherelemente.

Speicherelemente im binären Zustand 1 weisen eine Schwellenspannung mit tischen Verteilung innerhalb eines Bereiches 12 auf, wobei die von dem Bereich 12 umfassten Schwellenspannungen unterhalb einer Lesespannung 14 liegen. Die Lesespannung 14 wird von einem Vorrichtung, bspw. einer Speichervorrichtung, Welches auf die Speicherelemente zugreift, an die Speicherelemente angelegt, um den jeweiligen Zustand des Speicherelementes abzufragen. Speicherelemente in einem programmierten Zustand umfassen eine Schwellenspannung innerhalb einer statistischen Verteilung 16, wobei die Lesespannung 14 kleiner ist als die Schwellenspannungen der statistischen Verteilung 16.

Beim Anlegen der Lesespannung 14 an ein jeweiliges Speicherelement werden Speicherelemente mit einer Schwellenspannung innerhalb der statistischen Verteilung 12 als unprogrammiert und Speicherelemente mit einer Schwellenspannung innerhalb der statistischen Verteilung 16 als programmiert erkannt und so die gespeicherten Informationen ausgelesen. Ein Exponieren der Speicherelemente der ionisierenden Strahlung gemäß Schritt 102 des Verfahrens 100 oder Schritt 202 des Verfahrens 200 führt zu einer Verschiebung der statistischen Verteilung 16 in Richtung der statistischen Verteilung 12. Durch den Pfeil 18 ist angedeutet, dass dies anfänglich ohne Fehlerkennungen der einzelnen Speicherelemente erfolgt, solange die statistische Verteilung 16 bzw. sämtliche Schwellenspannungen der statistischen Verteilung 16 größer sind als die Lesespannung 14.

Bei einer Fortführung der Bestrahlung, welche in einer Erhöhung der von den Speicherelementen absorbierten Strahlungsdosis und einer reduzierten Konzentration der auf den jeweiligen Floating-Gates gespeicherten Ladungsträgern resultiert. Dadurch wird die statistische Verteilung 16 weiter in Richtung der statistischen Verteilung 12 verschoben. Dadurch wird die Schwellenspannung eines Teils oder sämtlicher ursprünglich programmierter Speicherelemente verringert, so dass sie kleiner ist, als die Lesespannung 14, wie es durch den Pfeil 22 angedeutet ist. Ist eine Schwellenspannung eines ursprünglich programmierten Speicherelements auf einen Wert unterhalb der Lesespannung 14 reduziert, so wird dieses Speicherelement trotz des ursprünglich programmierten Zustands als unprogrammiert identifiziert. Eine Anpassung (bspw. eine Reduzierung) der Lesespannung 14 kann jedoch solange zuverlässige Ergebnisse liefern, solange der Bereich der statistischen Verteilung 12 von dem Bereich der statistischen Verteilung 16 "getrennt" ist und die Lesespannung 14 zwischen die Bereiche der statistischen Verteilungen 12 und 16 angelegt werden kann.

Eine Datenvernichtung in diesem Zustand kann mit einer tieferen forensischen Analyse identifiziert werden, bspw. indem die Lesespannung reduziert wird. Der Zustand des Halbleiterbausteinskann dem einer digitalen Säuberung entsprechen. Bei einem analogem Zugriff auf die programmierten Halbleiterbausteine können analoge Signale, die auf eine Programmierung der Zellen hinweisen, durch erhöhte Schwellenwerte aufgrund möglicher Restladungen auf dem Floating-Gate ausgelesen werden. Eine fortgeführte Bestrahlung führt dazu, dass die statistischen Verteilungen 12und 16 einen gemeinsamen Bereich bilden.

Fig. 3b zeigt die statistischen Verteilungen der Speicherelemente analog Fig. 3a, nachdem die Speicherelemente die Solldosis absorbiert haben. Die statistische Verteilung 16 der Schwellspannungen ist basierend auf der Bestrahlung, beispielsweise basierend auf dem ausgelösten lonisierungseffekt, so weit reduziert, dass sie sich mit der statistischen Verteilung 12 der unprogrammierten Zellen überschneidet und einen Überlappungsbereich 24, bspw. in einem Umfang von zumindest 20 %, 30 %, 50 % oder 80 % der jeweiligen statistischen Verteilung bzw. der Summe an ursprünglich programmierten und unprogrammierten Speicherelementen. Eine resultierende statistische Verteilung 26 der Schwellspannungen aller Speicherelemente bildet einen zusammenhängenden Bereich. Die resultierende statistische Verteilung 26 weist am Ort des Bereichs 24, also am Ort, an dem sich die statistischen Verteilungen 12 und 16 überschneiden zwei lokale Maxima bzw. zwei Höcker auf. Durch die Bildung des gemeinsamen Bereichs 24 kann auch bei einer Veränderung der Lesespannung 14 nicht mehr sicher zwischen programmierten und unprogrammierten Speicherelementen unterschieden werden, da ein Anlegen einer Lesespannung 14 an die Speicherelemente zum Separieren der statistischen Bereiche 12 und 16 verhindert ist.

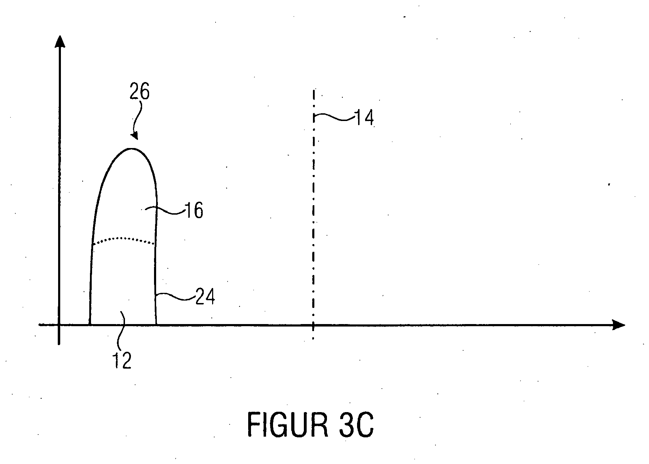

Fig. 3c zeigt die statistische Verteilung der Speicherelemente gemäß den Figuren 3a und 3b nach einer fortgeführten Bestrahlung der Speicherelemente. Der Überlappungsbereich 24 umfasst die statistischen Bereiche 12 der ursprünglich unprogrammierten Speicherelemente und der ursprünglich programmierten Speicherelemente nahezu vollständig, so dass die resultierende statistische Verteilung 26 der Speicherelemente in etwa einem Zustand entspricht in der alle Speicherelemente in einem unprogrammierten Zustand vorliegen; Um nach der Bestrahlung einen nahezu vollständigen Überlappungsbereich zu erhalten, kann beispielsweise eine gegenüber der Solldosis von Fig. 3b höhere Solldosis bestimmt werden, die von dem Halbleiterbaustein absorbiert wird. Fig. 3c zeigt einen Zustand der Speicherelemente; der eingestellt werden kann, wenn das Löschöbjekt über die absorbierte Solldosis zum Erreichen des in Fig. 3b dargestellten Zustandes hinaus bestrahlt wird.

Alternativ oder zusätzlich kann basierend auf verschiedenen Ionisationseffektern, die nachfolgend in Fig. 7 beschrieben werden, auch eine Verschiebung der statistischen Bereiche 12 in Richtung höherer oder niedrigerer Schwellenspannungen feststellbar sein. Ein durch Ionisationseffekte verursachter Löcherüberschuss in Isolationsmaterialien kann bspw. zu einer Verschiebung des statistischen Bereichs 12 und mithin die resultierende statistische Verteilung 26 in Richtung höherer Schwellenspannungen führen.

Nachfolgend eine shematische Darstellung des Löschens von Informationen in Speicherelementen beschrieben, die durch ein vorliegen in mehr als zwei Speicherzuständen eine größere Menge an Information repräsentieren können, beispielsweise MLC-Speicherelemente, die vier logische Zustände annehmen können, welche durch die Bit-kombinationen "11", "10", "01" und "00" darstellbar sind.

Nachfolgend wird Bezug nehmend auf Fig. 7 der Einfluss der Bestrahlung auf Speicherelemente eines MLC Halbleiterbausteins erläutert. Fig. 7 zeigt eine schematische Darstellung der Effekte ionisierender Strahlung auf ein Flash-Speicherelement eines Halbleiterbausteins. Ein Effekt A der Fig. 7 beschreibt eine Neutralisation von Ladungsträgern auf dem jeweiligen Floating-Gate des jeweiligen Speicherelementes. Effekt B beschreibt ein Einfangen von Ladungsträgern in Isolationsschichten, welche das jeweilige Floating-Gate umgeben. Das Einfangen führt zu einer Maskierung von auf dem Floating-Gate gespeicherten Ladungsträgern. Effekt C beschreibt eine Photoemission durch Anregung von auf dem jeweiligen Floating-Gate gespeicherten Ladungsträgern die ionisierende Strahlung.

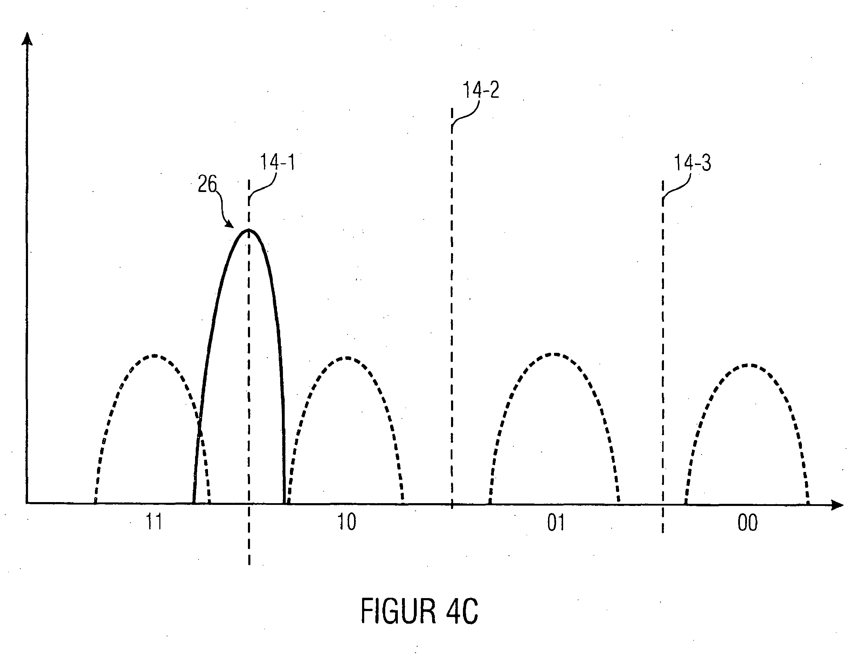

Fig.4 azeigt statistische Verteilung 12 der unprogrammierten Speicherelemente und der statischen Verteilungen 16-1, 16-2 und 16-3 der programmierten Speicherelemente, die jeweils durch die Lesespannungen 14-1, 14-2 und 14-3 von einander unterscheidbar sind. Die statistischen Verteilungen liegen beispielhaft gleichverteilt in dem unprogrammierten Zustand "11" und den programmierten Zuständen "10", "01" und "00" vor, wobei die statistischen Verteilungen, abhängig von den gespeicherten Daten eine beliebige Verteilung aufweisen können.

Fig. 4b zeigt schematisch das Vorliegen aller Speicherelemente im Zustand "11" nach einer erfolgten Bestrahlung, so dass aus einem Speicherelement nach der Bestrahlung aus dem Zustand "11" nicht gefolgert werden kann, welchen .Zustand das jeweilige Speicherelement vor der Bestrahlung aufgewiesen hat. Nach Erreichen der Solldosis durch die Bestrahlung werden die Speicherzustände der Speicherelemente basierend auf dem lonisationseffekt jeweils derart beeinflusst, dass die Speicherzustände nach dem Bestrahlungsvorgang unabhängig von den Speicherzuständen vor dem Bestrahlungsvorgang sind. Durch Zerstörung dieses Zusammenhangs ist eine Rekonstruktion der ursprünglichen Daten verhindert. Der gemeinsame Bereich 26 weist dabei bezüglich der Schwellenspannungen der Speicherelemente eine Breite ΔV_{SW} auf, in welchem die Schwellenspannungen der Speicherelemente verteilt sind. Die Breite ΔV_{SW} kann dabei von mehreren Faktoren beeinflusst sein, wie etwa den Umfang oder die Gewichtung einzelner Ionisierungseffekte, die während der Bestrahlung auftreten und in Fig. 7 erläutert werden. Treten Effekte A und C mit einer großen Gewichtung bezüglich aller Ionisierungseffekte auf, so kann die Breite ΔV_{SW} geringer sein, als bei einem Auftreten der Effekte A und C mit einer geringen Gewichtung. Bei einer größeren Gewichtung sind möglicherweise nahezu alle. Ladungsträger auf den Floating-Gates der Speicherelementen neutralisiert, so dass die Speicherelemente untereinander geringe Abweichungen bzgl der verbleibenden Ladungsträger aufweisen und mithin der Bereich der resultierenden statistischen Verteilung 26 eine geringe Breite ΔV_{SW} zeigt. Eine Höhe X der resultierenden statistischen Verteilung 26 kann von der Anzahl der Speicherelemente und der Breite ΔV_{SW} abhängen, so dass eine größere Breite ΔV_{SW} zu einer geringeren Höhe X und umgekehrt .führen kann, wobei eine Fläche der statistischen Verteilung 26 konstant bleibt.

Fig. 4c zeigt schematisch das Vorliegen der Schwellenspannungen aller Speicherelemente in der gemeinsamen statistischen Verteilung 26. Der in Fig. 7 erläuterte Effekt B führt zu einer Verschiebung der statistischen Verteilung 26 in Richtung höherer Schwellenspannungen. Die durch den Effekt B generierten Löcher erzeugen gegenüber negativen Ladungen der auf dem Floating-Gate gespeicherten Ladungsträger positive Ladungen in Form von Löchern. Ein Löcherüberschuss kann zu einer Verschiebung der anzulegenden Schwellenspannung führen.

Die resultierende statistische Verteilung 26 kann auch eine andere Form mit einer oder mehreren lokalen Maxima aufweisen, wie es in Fig. 3b dargestellt ist. Eine "Höckerbildung" kann bspw. während der Bestrahlung resultieren, wenn die statistische Verteilungen 12, 16-1, 16-2 und 16-3 in einander "wandern" und die gemeinsame statistische Verteilung 26 bilden.

Prinzipiell kann in Abhängigkeit des Einflusses der einzelnen lonisationseffektedie Höhe die Breite und/oder die Position der resultierenden statistischen Verteilung 26 an der Achse der Schwellwertspannungen variieren. Eine Abhängigkeit des Einflusses kann bspw. bezüglich dem eingesetzten Bestrahlungsverfahren bzw. von einer eingesetzten Strahlungsquelle bestehen. Eine Elektronenstrahlung einer entsprechenden Quelle kann bspw. gegenüber einer Protonenstrahlung oder einer Schwerionen-Strahlung zu einer ,anderen Gewichtung der einzelnen Effekte A, B und/oder C führen.

Fig. 5a zeigt einen schematischen Aufbau eines Speicherelementes beispielhaft in Form eines Metal Oxide Semiconductor Field Effect Transistor (MOSFET), der um ein Floating-Gate 32 erweitert ist, so dass der MOSFET neben einem Control-Gate 34, einer Source 36 und einem Drain 38 vier leitfähige Komponenten, beispielsweise in Form eines jeweiligen Halbleiterelements; aufweist. Das Floating-Gate 32 ist gegenüber den anderen leitenden Elementen 34, 36 und 38 durch Isolatoren 42a und 42b isoliert. In einem unprogrammierten Zustand des Speicherelements ist eine geringe Konzentration an Ladungsträgern auf dem Floating-Gate 32 gespeichert, so dass in einem elektrisch unkontaktierten Zustand des Speicherelements ein relativ homogener Potentialverlauf über einen Verlauf des Speicherelements ausgebildet ist, wie es durch die gestrichelte Linie 44 angedeutet ist.

Fig. 5b zeigt die schematische Darstellung des MOSFET analog Fig. 5a in einem programmierten Zustand des Speicherelements unter Bezugnahme auf Fig. 6. Fig. 6 zeigt eine schematische Darstellung des Verlaufs des Drain-Stroms an einem MOSFET in Bezug auf eine angelegte Spannung am Control-Gate. Auf dem Floating-Gate 32 sind Ladungsträger 46 gespeichert. Diese führen zu einem Potential-Öffset im Bereich des Floating-Gates 32, wie es durch den Verlauf der gestrichelten Linie 44 angedeutet ist. Die Ladungsträger 32 führen zu einer Verschiebung der Kennlinie des Drain-Stroms bezüglich einer am Control-Gate 28 angelegten Spannung, wie es in Figur 6 dargestellt ist.

Das Floating-Gate ist vollständig von isolatormaierial 42a und 42b umgeben, was den Namen "Floating-Gate" begründet. Werden beispielsweise Elektronen auf das Floating-Gate 32 aufgebracht, so schirmen diese das am Control-Gate 34 anliegende elektrische Feld ab und es kommt zu einer Verschiebung der Kennlinie des Speicherelements, wie es in Fig. 6 gezeigt ist. Ein Einbringen der Ladungsträger 46, beispielsweise in Form von Elektronen, und mithin ein Programmieren der Speicherelemente kann beispielsweise derart erfolgen, dass die Elektronen eine Potentialbarriere des Isolators 42a, 42b über-springen, was als Hot-Channel-Injection bezeichnet ist und beispielsweise bei NOR-Flash-Speichern angewendet wird. Alternativ oder zusätzlich können die Elektronen die` Potentialbarriere mittels des sogenannten Fowler-Nordheim-Tunneln durchtunneln, wie es beispielsweise bei NAND-Flash-Speichern angewendet wird, indem jeweils geeignet hohe Spannungen an die Speicherelemente angelegt werden. Eine Löschung der Zellen erfolgt elektrisch im Allgemeinen über das Fowler-Nordheim-Tunneln. Liegt an der Speicherzelle keine Spannung an, bleibt die Ladung im Floating-Gate gefangen, das bedeutet "gespeichert", bis sie über kleinste, bzw. minimale Leckströme im Isolator über einen Zeitraum von beispielsweise 10 bis 100 Jahren entweicht.

Fig. 6 einen schematischen Graph mit Spannung-Strom-Kurven einer unprogrammierten und einer programmierten Speicherzelle eines MOSFET. Die Abszisse des Graphen zeigt eine an einer Speicherzelle bzw. einem Speicherelement angelegte Control-Gate-Spannung. Die Ordinate des Graphen zeigt den Source-Drain-Strom als Funktion der angelegten Control-Gate-Spannung. Eine Kennlinie 48 eines unprogrammierten Speicherelements zeigt, däss bei Anlegen der Lesespannung 14 am Control-Gate des Speicherelements ein Source-Drain-Strom des Speicherelements fließen kann. Wird die Lesespannung 14 an ein programmiertes Speicherelement angelegt, so zeigt eine Kennlinie 52 des programmierten Speicherelements, dass die Lesespannung 14 kleiner ist als eine. Schwellenspannung; oberhalb derer der Transistor des Speicherelements leitend wird und oberhalb derer ein Source-Drain-Strom fließt. Die Kennlinie 48 des unprogrammierten Speicherelements verläuft mit einem Versatz 54 in etwa parallel zu der Kennlinie 52 des programmierten Speicherelements. Der Versatz 54 entspricht einem durch ein Delta bzgl. der Schwellenspannung darstellbaren Unterschied der Schwellenspannungen zwischen programmierten und unprogrammierten Speicherelementen. Wird eine definierte Lesespannung 14 an das Control-Gate angelegt, so fließt bei einer programmierten Zelle kein Strom zwischen Source und Drain, während bei einer gelöschten Zelle ein nachweisbarer Strom fließt.

Fig. 7 zeigt eine schematische Darstellung der Effekte ionisierender Strahlung auf ein Flash-Speicherelement eines Halbleiterbausteins in einem Bändermodell. Isolatoren 42ä und 42b trennen als Bandlücke die Valenzbänder der Control-Gate 34, Source-Gate 36 und Drain-Gate 38 von dem Floating-Gate 32. Die ionisierende Strahlung 56 führt dazu, dass in einem Effekt A in den, das Floating-Gate 32 umgebenden, Isolatoren 42a und 42b Ladungen 58 erzeugt Werden, die in das Floating-Gate 32 eindringen und dort Ladungsträger 46 neutralisieren. In einem Effekt B wird durch die ionisierende Strahlung 56 Ladung in den Isolatoren erzeugt, bspw in Form von Löchern, die eine den Ladungsträgern 46 entgegen gerichtete Ladung aufweisen, die dort "gefangen" (trapped) ist und mit dem erzeugten Potential einen Teil der Ladungsträger bzw. des Potentials der Ladungsträger auf dem Floating-Gate maskiert, was zu einer Neutralisierung eines Teils der auf den Floating-Gate 32 gespeicherten Ladungsträger führen kann. Die Einflüsse des Effektes B können zumindest teilweise oder vollständig temporär sein. So können bspw diese Einflüsse durch ein Erwärmen der Speicherelemente zumindest teilweise dadurch reduziert (ausgeheilt) werden, dass gefangene Löcher unter Temperatureinfluss mit Elektronen rekombinieren und neutralisiert werden. Bei einem Effekt C regt die ionisierende Strahlung 56 die Ladungen 46 energetisch an, so dass die Ladungen 46 genug Energie auf-weisen, um die Potentialbarriere des Isolators 42a bzw. 42b zu überwinden und die Konzentration der Ladungsträger 46 im Floating-Gate 32 sinkt. Effekt B kann bei geringen Dicken der Isolationsschichten 42a und 42b gegenüber den Effekten A und C gering sein. Sind alle, beziehungsweise nahezu alle Ladungsträger 46 durch die Effekte A und C von dem Floating-Gate 32 entfernt, bzw. durch die Effekte A-C neutralisiert und damit die Konzentration der Ladungsträger auf dem Floating-Gate hinreichend stark reduziert, ist ein Löschzustand erreicht, der einer analogen Löschung beziehungsweise Säuberung entspricht.

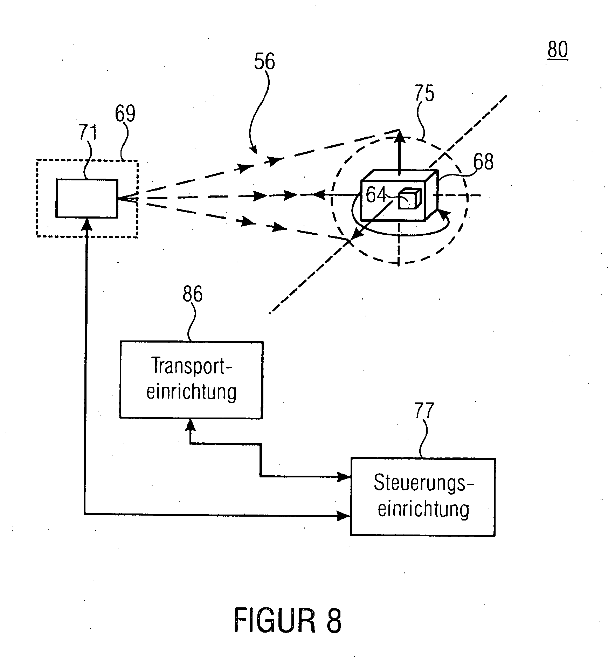

Fig. 8 zeigt eine Prinzipdarstellung einer Vorrichtung 80 zur automatischen Positionierung eines z. B. in einem Behälter 68 angeordneten Halbleiterbausteins 64. Die Löschvorrichtung 80 weist eine Bestrahlungseinrichtung 69 mit einer Strahlungsquelle 71 zum Emittieren einer ionisierenden Strahlung 56 auf, um einen Bestrahlungsbereich 75 zu bestrahlen. Prinzipiell kann die ionisierende Strahlung jedwede Art von ionisierender Strahlung sein, bspw. eine Photonenstrahlung, eine Elektronenstrahlung, eine Neutronenstrahlung, einer Teilchenstrahlung wie etwa eine Protonenstrahlung oder eine Strahlung mit Schwerionen;

Die Vorrichtung 80 weist ferner eine Transporteinrichtung 86 auf, die ausgebildet ist, um den Halbleiterbaustein 64 bzw. den Behälter 68 von einer Anfangsposition zu einer Endposition bzgl. des Bestrahtuhgsvorgangs mit einer (durchschnittlichen) Transportgeschwindigkeit zu bewegen. Die Transportgeschwindigkeit kann zum Beispiel zumindest abschnittsweise konstant oder auch abschnittsweise variabel sein. Ferner kann die Bewegung auch bspw. zeitweise angehalten werden, um den Halbleiterbaustein 64 bzw. den Behälter 68 an einer gewählten Bestrahlungsposition zu halten. Die Transporteinrichtung 86 kann bspw. ein Fließ- oder Förderband sein, auf Welchem der Halbleiterbaustein 64 an der Strahlungsquelle 69 vorbeigeführt und bestrahlt wird.

Die Tranporteinrichtung 86 ist ferner ausgebildet, um den Halbleiterbaustein durch eine Relativbewegung relativ zu der Strahlungsquelle 69 zu bewegen bzw. auszulenken. Die Relativbewegung kann bspw. eine Drehung des Behälters 68 oder eine horizontale und/oder vertikale Verschiebung wie etwa mit einer Kranvorrichtung beinhalten. So können sich beispielsweise eine Vielzahl von zu bestrahlenden Halbleiterbausteinen 64 in einer Vielzahl von Behältern 68 auf einer Transporteinrichtung 86, befinden, die die zu bestrahlenden Halbleiterbausteine 68 in die jeweilige(n) Löschbereich(e) bewegt. Ein jeweiliger Behälter kann in dem Löschbereich abgelegt öder die Transporteinrichtung 86 angehalten werden, bis die Solldosis von den Halbleiterbausteine absorbiert ist und anschließend aus dem Bestrahlungsbereich herausbewegt werden ("Stop and Go" Betrieb). Alternativ kann ein Behälter auch mit einer konstanten oder variablen Transportgeschwindigkeit in einem kontinuierlichen Betrieb durch den Bestrahlungsbereich hindurchgefahren werden.

So kann der Behälter vor der Strahlungsquelle 69 gedreht werden, um eventuelle Absorptions-"Schatten" der ionisierenden Strahlung, bzw. der Löschstrahlung 56 in dem jeweiligen Behälter 68 zu reduzieren und eine vollständige Durchdringung der Halbleiterbausteine mit der Löschstrahlung 56 zu erreichen. Alternativ kann die Transporteinrichtung 86 bspw. einen Greifarm umfassen, der an einem Schienensystem beweglich angeordnet ist und ausgebildet ist, um den Behälter 68 zu greifen und mit der Transportgeschwindigkeit an der Strahlungsquelle 69 vorbei zu bewegen und mit der Relativbewegung vor der Strahlungsquelle 69 zu drehen (d. h. zumindest in einer Raumachse auszulenken)..

Alternativ oder zusätzlich kann der Behälter 68 auch auf der Transporteinrichtung 86mit der Transportgeschwindigkeit an der Strahlungsquelle 69 vorbeigeführt werden, um die Halbleiterbausteine einer kontinuierlichen Bestrahlung auszusetzen.

Wird der Halbleiterbaustein 64, bzw. der Behälter 68 durch den Bestrahlungsbereich 75 geführt, so kann die Transportgeschwindigkeit so eingestellt sein, dass eine zur Durchquerung des Löschbereichs benötigte Zeit zumindest so lange ist, dass der Halbleiterbaustein die Solldosis der ionisierenden Strahlung 56 absorbiert.

Alternativ kann der Behälter 68 auch in dem Bestrahlungsbereich 75 abgelegt und nach einer Bestrahlungszeit, in welcher der Behälter 68 bzw. der Halbleiterbaustein 64 mit der ionisierenden Strahlung 56 bestrahlt wird und nach der die Solldosis absorbiert ist, aus dem Bestrahlungsbereich 75 herausbewegt werden. Alternativ oder zusätzlich kann ein Behälter 68 bspw. von der Transporteinrichtung 86 gedreht werden und anschließend der ionisierenden Strahlung 56 exponiert werden bis ein Teil der Solldosis von dem Halbleiterbaustein 64 absorbiert ist. Nachdem der Teil der Solldosis absorbiert ist, kann der Behälter 68 weiter gedreht oder bewegt werden, um daraufhin mit einem anderen Winkel oder einer anderen Ausrichtung bezüglich der Strahlungsquelle 69 bestrahlt zu werden und einen weiteren Teil der Solldosis zu absorbieren. Alternativ oder zusätzlich kann der Behälter 68 der ionisierenden Strahlung 56 auch während des Bewegens oder Drehens exponiert werden.

Eine Steuerungseinrichtung 77 ist ausgebildet, um die Transporteinrichtung 86 und die Strahlungsquelle 69 zu steuern. So kann die Steuerungseinrichtung 77 bspw. die Transportgeschwindigkeit und/oder eine Drehgeschwindigkeit mit der die Relativbewegung erfolgt, in Abhängigkeit des jeweiligen Löschobjektes mit dem zu löschenden Halbleiterbaustein 64 justieren, um bei einer konstanten Strahlungsintensität der Löschstrahlung 56 und variierenden Absorptionsgraden der Löschobjekte mit variierenden Transportgeschwindigkeiten oder variierenden Zeitdauern, in denen das Löschobjekt in dem Löschbereich abgelegt ist, eine Absorption der jeweiligen Solldosis zu erreichen.

Mit der Vorrichtung 80 kann ein kontinuierlicher Löschprozess ausgeführt werden das bedeutet, dass eine Mehrzahl an Behältern 68 auf der Transporteinrichtung 86 ablegbar ist und nacheinander bestrahlt werden können.

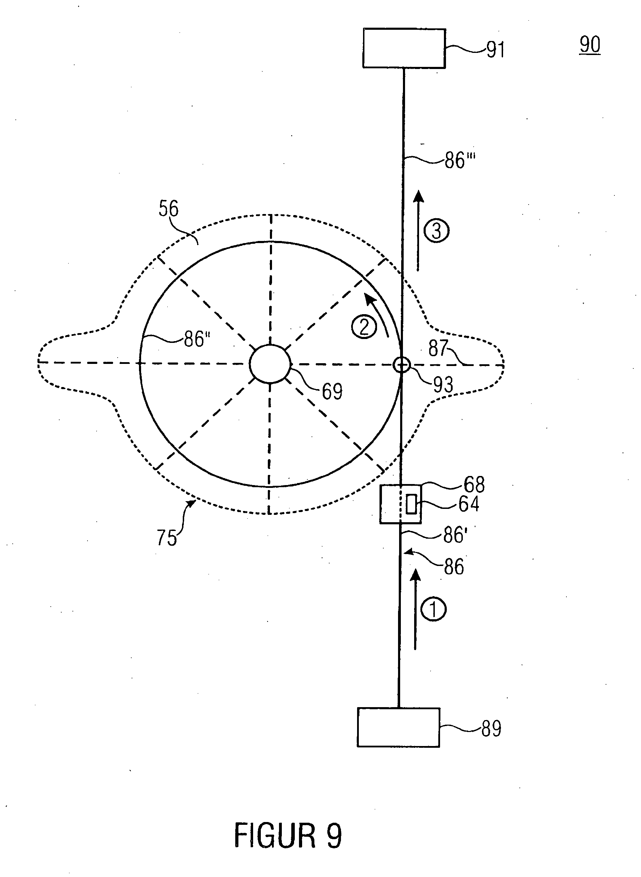

Fig. 9 zeigt eine schematische Aufsicht auf eine Vorrichtung 90 zur Bestrahlung eines Halbleiterbausteins 64 mit der Strahlungsquelle 69 die z. B. in einer Bestrahlungsebene die ionisierende Strahlung 56 emittiert und den Bestrahlungsbereich 75 bestrahlt. Die emittierte ionisierende Strahlung 56 weist eine Vorzugsrichtung 87 in der Bestrahlungsebene auf, in der eine Intensität der ionisierenden Strahlung 56 größer ist, als in den anderen Richtungen, so dass der wirksame Bestrahlungsbereich 75 (bzgl. des wählbaren Abstands der Strahlungsquelle 69 zum Halbleiterbaustein 64) in der Vorzugsrichtung 87 (x-Richtung) vergrößert ist. Die Vorrichtung 90 weist eine Transporteinrichtung 86 mit einem ersten Abschnitt 86', einem zweiten Abschnitt 86" und einem dritten Abschnitt 86''' auf. Die Abschnitte 86' und 86"' sind um die Koppelstelle 93 herum teilweise, d. h. in Sektionen, innerhalb des Bestrahlungsbereichs 75 angeordnet, so dass die Abschnitte 86' und 86''' teilweise der ionisierenden Strahlung 56 exponiert sind. Ein Halbleiterbaustein, welcher in den der ionisierenden Strahlung 56 exponierten Sektionen bewegt oder positioniert wird, kann einen Teil der Strahlung 56 absorbieren. Die Transporteinrichtung 86 ist ausgebildet, um den Halbleiterbaustein 64 bzw. den Behälter 68 mit dem Halbleiterbaustein 64 von der Anfangsposition bzw. dem Übernahmebereich 89, bspw eine Anlieferungszone zu der Endposition bzw. Übergabebereich 91, bspw. eine Übergabezone der Vorrichtung 90, entlang der Abschnitte 86', 86''' und ggf. 86" zu bewegen. Der Halbleiterbaustein 64 absorbiert während der Bewegung innerhalb des Bestrahlungsbereichs 75 die Solldosis, bspw. indem der Halbleiterbaustein 64 im Abschnitt 86" um die Strahlungsquelle 69 herum bewegt wird. Alternativ kann der Hälbleiterbaustein 64 die Solldosis in den Sektionen der Abschnitte 86' und 86", in welchen der Halbleiterbaustein der ionisierenden. Strahlung 56 exponiert ist, an der Strahlungsquelle 69 vorbei geführt werden und die Solldosis absorbieren.

Die Transporteinrichtung 86 ist beispielsweise als Schienensystem ausgeführt und ausgebildet, um in einer ersten Phase 1 den Behälter 68 von dem Anfangsbereich 89 in Richtung der Strahlungsquelle 69 zu bewegen. Innerhalb des durch die Vorzugsrichtung 87 beeinflussten Bestrahlungsbereichs 75 wird der Halbleiterbaustein 64 der ionisierenden Strahlung 56 exponiert. Eine Auskoppelstelle 93, bspw. eine Weiche der Transporteinrichtung 86', ist ausgebildet, um den Behälter 68 ggf. auf den Abschnitt 86" zu führen. In einer zweiten, optionalen Phase 2 wird der Halbleiterbaustein 64 im Abschnitt 86" um die Strahlungsquelle 69 herumbewegt, bis die Solldosis von dem Halbleiterbaustein 64 nahezu: oder vollständig absorbiert ist. Dazu kann bspw. die Geschwindigkeit des Halbleiterbausteins 64 auf dem Abschnitt 86" oder eine Anzahl von Umrundungen des Halbleiterbausteins 64 bezüglich der Strahlungsquelle 69 im Abschnitt 86" variiert werden. In einer Phase 3, die auf die Phase 1 oder ggf. auf die optionale Phase 2 folgt, wird der Halbleiterbaustein 64 an der Auskoppelstelle 93 auf den Abschnitt 86''' gelenkt und in Richtung des Endbereichs 91 aus dem Bestrahlungsbereich 75 heraus bewegt, so dass bei Erreichen des Endbereichs 91 die Solldosis absorbiert ist.

Die Transporteinrichtung 86 kann so ausgebildet sein, dass der Haibteiterbaustein 64 im Abschnitt 86" mit einer über die Zeit variierenden Geschwindigkeit bewegt wird und/oder stellen- und/oder zeitweise unbewegt bleibt. Alternativ oder zusätzlich kann die Transporteinrichtung 86 so ausgebildet sein, dass der Halbleiterbaustein 64 mit einer konstanten Geschwindigkeit an der Strahlungsquelle 69 vorbei, bzw. um die Strahlungsquelle 69 herum bewegt wird.

Vorrichtung 90 ermöglicht eine Bestrahlung von Behältern oder Halbleiterbausteinen bzw Löschobjekten mit variierenden zu absorbierenden Solldosen. So kann ein Behälter 68 bspw. in Phase 2 einmal im Abschnitt 86" um die Strahlungsquelle 69 herumgeführt werden, um eine erste Solldosis zu absorbieren. Ein nachfolgender Behälter 68 kann in Phase 2, bspw. aufgrund einer größeren Anzahl von Löschobjekten im Behälter, in Phase 2 zwei oder mehrmals um die Strahlungsquelle 69 herumgeführt werden, um eine zweite Solldosis zu absorbieren. Ein weiterer Behälter kann bspw. lediglich die Phasen 1 und 3 passieren, da eine dritte Solldosis bereits während der Bewegung des Behälters entlang der Abschnitte 86' und 86"von dem Halbleiterbaustein absorbiert wird.

Zur ein- oder mehrmaligen Führung eines Behälters 68 um die Strahlungsquelle 69 herum kann der Abschnitt 86" und/oder die Abschnitte 86' bzw. 86''' mehrere Ebenen bzw. Etagen umfassen. So ist beispielsweise vorstellbar, dass die Transporteinrichtung 86 eine erste und eine zweite Etage aufweist, wobei der der Abschnitt 86' in der ersten Etage und der Abschnitt 86''' in der zweiten Etage angeordnet ist. Die Koppelstelle 93 ist ausgebildet, um einen Behälter 68 aus dem Abschnitt 86' bei einer ersten Ankunft auszukoppeln so dass der Behälter 68 in einer ersten Richtung auf der ersten Etage um die Strahlungsquelle 69 herumgeführt wird. Die Koppelstelle 93 ist ferner ausgebildet, um den Behälter 68 bei einem zweiten Erreichen, das auf das erste Erreichen folgt, in die zweite Etage, bspw. durch einen Lift, zu bewegen, so dass der Behälter 68 z. B. in einer zweiten Richtung, die der ersten Richtung entgegengerichtet ist, um die Strahlungsquelle 69 herumgeführt wird. Die Koppelstelle 93 ist beispielsweise ferner ausgebildet, um den Behälter 68 bei einem dritten Erreichen der Koppelstelle 93 wieder in die erste Etage zu bewegen, um den Behälter entweder erneut um die Strahlenquelle 69 herumzuführen und die Schritte die nach dem ersten Erreichen der Koppelstelle 93 durchgeführt worden sind zu wiederholen oder, um den Behälter beim dritten Erreichen auf den Abschnitt 86''' zu bewegen, wenn die erforderliche Solldosis absorbiert ist.

Generell kann die Transporteinrichtung 86 beliebig viele Etagen umfassen, beispielsweise eine, zwei oder mehrere Etagen.

Die Vorrichtung kann optional ein Absorberbecken umfassen, welches einen Absorberstoff, bspw. Wasser, aufweist und benachbart zur Strahlungsquelle angeordnet ist. Die Vorrichtung ist bspw. ausgebildet, um die Strahlungsquelle gegebenenfalls, bspw. während einer Stilllegung zu Wartungszwecken, in das Absorberbecken bewegt und von dem Absorberstoff bedeckt oder umschlossen zu werden, sodass der Bestrahlungsbereich wesentlich reduziert wird oder innerhalb des Absorber angeordnet ist.

Alternativ zu dem Schienensystem kann die Transporteinrichtung 86 auch eine anderes Transportsystem, bspw. einen beweglichen Kran, aufweisen.

Alternativ ist ebenfalls denkbar, dass die Strahtungsquette 69 keine Vorzugsrichtung oder mehrere, bspw. zwei Vorzugsrichtungen 87 aufweist. Wenn die Strahlungsquelle 69 keine Vorzugsrichtung 87 aufweist, so bestrahlt die Strahlungsquelle 69 einen runden bzw. annähernd runden Bereich. Mehrere Vorzugsrichtungen 87 können bspw. derart genutzt werden, dass zu bestrahlende Halbleiterbausteine 64 oder Behälter 68 bezüglich der Strahlungsquelle 69 an Orten in jeweils einer Vorzugsrichtung auf der Transporteinrichtung 86 temporär verlangsamt oder angehalten werden. Dies kann eine größere Absorption einer Dosis der ionisierenden Strahlung 56 an diesen Orten ermöglichen und bspw. eine Anzahl von Durchläufen der Phase 2 reduzieren, so dass bezüglich des Durchsatzes zu Bestrahlender Löschobjekte durch die Vorrichtung 90 eine Erhöhung erzielbar sein kann. Keine Vorzugsrichtung bedeutet, dass der Bestrahlungsbereich 75 kreisförmig oder konzentrisch ausgeformt ist und die Strahlendosis kontinuierlich von dem Halbleiterbaustein absorbiert werden kann.

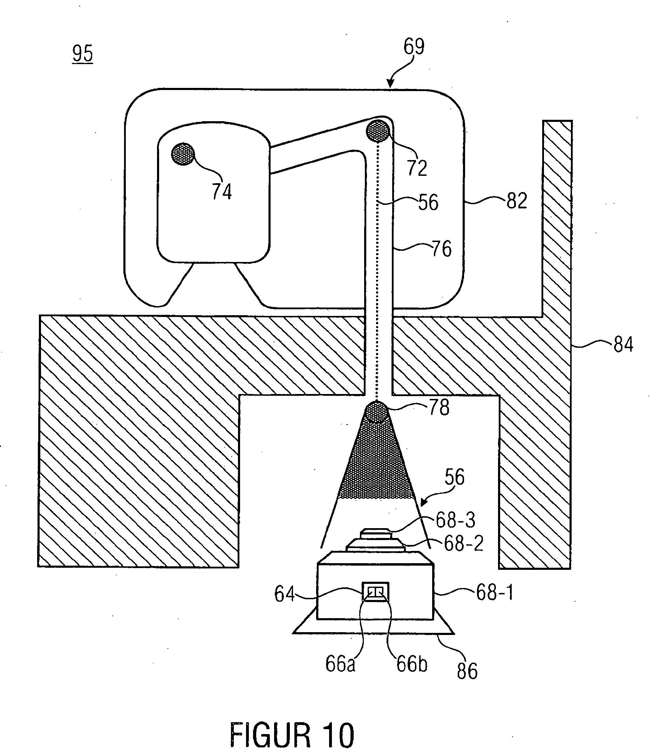

Fig.10 zeigt eine schematische Darstellung einer Vorrichtung 95 zum Löschen von Infomationen, die auf einem elektronischen Halbleiterbaustein mit einer Vielzahl von nicht flüchtigen Speicherelementen gespeichert sind. Die Vorrichtung 95 umfasst eine Bestrahlungseinrichtung bzw. Strahlungsquelle 69, die ausgebildet ist, um einen Halbleiterbaustein 64 zu bestrahlen. Der Halbleiterbaustein 64 umfasst eine Vielzahl von Speicherelementen 66a und 66b. Der Speicherbaustein 64 ist in einem Behälter 68-1 angeordnet, der für die ionisierende Strahlung 56 derart durchlässig .ist, dass von dem Halbleiterbaustein 64 während der Bestrahlung die Solldosis der ionisierenden Strahlung 56 absorbiert wird. Die Strahlungsquelle 69 ist hier beispielhaft ausgebildet, um den Halbleiterbaustein 64 mit einer Elektronenstrahlung zu bestrahlen. An einer Katode 72 werden bei Anlegen einer Hochspannung, welche von einer Hochspannungserzeugung 74 generiert wird, Elektronen über eine Beschleunigerröhre 76 beschleunigt. Ein Scanner 78 der Vorrichtung 95 ist ausgebildet, um die von der Katode 72 abgestrahlten Elektroden umzulenken. Die Katode 72 und die Beschleunigerröhre 76 sind dabei in einem Drucktank 82 angeordnet, der ausgebildet ist, um die ionisierende Strahlung 56 in Form von Elektronen abzuschirmen. Die Strahlungsquelle 69 ist von einem Bereich, in welchem der Halbleiterbaustein 64 bestrahlt wird, durch eine Abschirmung 84, beispielsweise in Form einer Betonstruktur. Die ionisierende Strahlung 56 kann den Behälter 68-1 und den Halbleiterbaustein 64 durchdringen, wobei die zuvor beschriebenen lonisationseffekte auftreten, so dass Ladungen auf dem Halbleiterbaustein 64 durch die ionisierende Strahlung 56 reduziert und Daten oder Informationen gelöscht werden.

Der Scanner 78 ist ausgebildet, um die ionisierende Strahlung 56 umzulenken. Damit kann der Halbleiterbaustein 64 aus unterschiedlichen Winkeln mit der ionisierenden Strahlung 56 bestrahlt werden. So können eventuelle Bereiche des Halbleiterbausteins 64, welche aufgrund temporärer Abschirmungseffekte mit einem geringeren Anteil der ionisierenden Strahlung 56 bestrahlt werden, aus einer anderen Richtung zusätzlich bestrahlt werden, um die Solldosis zu absorbieren. Beispielsweise können in dem Behälter 68-1 mehrere Halbleiterbausteine 64, Speichervorrichtungen oder Systeme angeordnet sein, so dass in einer Strahlrichtung der ionisierenden Strahlrichtung 56 eine Strahlungsintensität der ionisierenden Strahlung 56 abnimmt, insbesondere wenn entlang der Strahlrichtung mehrere Halbleiterbausteine 64 von der Strahlung 56 durchdrungen werden. Eine Bestrahlung der in der Strahlrichtung nachfolgenden Halbleiterbausteine aus einer anderen Richtung kann somit zu einer optimierten Absorption der Strahlungsdosis führen. Der Behälter 68-1 ist auf einer Transporteinrichtung 86, beispielsweise ein Fließband, angeordnet, welches ausgebildet ist, den Behälter 68-1 und darin angeordnete Systeme, Speichervorrichtungen und/oder Halbleiterbausteine an der ionisierenden Strahlung 56 vorbeizuführen. Auf der Transporteinrichtung 86 sind weitere Behälter 68-2 und 68-3 angeordnet, so dass mit der Vorrichtung 95 nacheinander mehrere Behälter 68-1, 68-2 und 68-3 bestrahlt werden können und ein kontinuierlicher Löschprozess realisiert werden kann.

Alternativ oder zusätzlich können die Behälter 68-1, 68-2 und 68-3 auf dem Fließband 86 gedreht werden, um eine zusätzliche Variation der Bestrahlungsrichtung und Bestrahlungswinkel zu ermöglichen.

Alternativ oder zusätzlich kann durch die Transporteinrichtung 86 auch eine automatische Positionierung der Behälter 68-1, 68-2 oder 68-3 bezüglich der Bestrahlungseinrichtung 69, d.h. bezüglich der Strahlungsquelle, erfolgen. Die Positionierung kann beispielsweise basierend auf einer Eingabe eines Bedieners der Anlage erfolgen oder vordefiniert sein, sodass sie Anlage ausgebildet ist, eine automatische Positionierung der Behälter 68-1, 68-2 oder 68-3 durchzuführen. Eine automatische oder durch eine Benutzereingabe bestimmte Positionierung kann beispielsweise dazu genutzt werden, um bei wechselndem Inhalt unterschiedlicher Behältern stets eine geeignete Streuung der Strahlung oder einen geeigneten Abstand zwischen der Strahlungsquelle und den zu bestrahlenden Halbleiterbausteinen einzustellen.

Alternative Ausführungsbeispiele zeigen Bestrahlungseinrichtungen, die ausgebildet sind, den Halbleiterbaustein mit einer Photonenstrahlung, einer Neutronenstrahlung, einer Protonenstrahlung oder einer von Schwer-lonen-Strahlung zu bestrahlen. Unterschiedliche Strahlungsarten weisen bezüglich Kosten, Bestrahlungsenergie oder Durchdringungsvermögen unterschiedliche Vorteile auf. Eine Photonenstrahlung kann beispielsweise durch Übergänge angeregter Atomkerne oder durch Abbremsen geladener Teilchen, beispielsweise Röntgenstrahlung erzeugt werden. Photonen können eine indirekt ionisierende Strahlung mit hoher Durchdringung bilden. Energien einer Photonenstrahlung können zwischen 200 keV und 1.500 keV, zwischen 300 keV und 1.500 keV, zwischen 1.000 keV und 1.500 keV, zwischen 600 keV und 1.400 keV oder zwischen 1.000 keV und 8.000 keV liegen. Anlagen zur Generierung einer Photonenstrahlung können relativ kostengünstig realisiert weden.

Eine Elektronenstrahlung kann durch Teilchenbeschleuniger generiert werden. Die Elektronenstrahlung bildet eine direkt ionisierende Strahlung mit mittlerem Durchdringungsvermögen, wobei Energien der Elektronenstrahlung bei z. B. zumindest 100 keV bis hin zu 10.000 keV, zwischen 1.000und 8.000, zwischen 3.000 und 6.000 keV oder zwischen 4.000 keV und 5.000 keV liegen können. Elektronenstrahlung kann kostengünstig generiert werden.

Eine Protonenstrahlung kann durch einen Teilchenbeschleuniger generiert werden und bildet eine direkt ionisierende Strahlung mit geringem Durchdringungsvermögen. Eine Protonenstrahlung kann Energien von z. B. zumindest 10 keV bis hin zu 600 MeV, zwischen 1 MeV und 600 MeV oder zwischen 100 MeV und 500 MeV aufweisen, wobei Anlagen zur Erzeugung von Protonenstrahlung relativ zu anderen Strahlungsarten kostenintensiv sein können. Mit Protonenstrahlung bestrahlte Materialien .können durch die Bestrahlung radioaktiv werden, was dazu führen kann, dass die bestrahlten Materialien auf längere bis unbestimmte Zeit an der Bestrahlungsanlage verbleiben.

Eine Neutronenstrahlung kann analog zu der Protonenstrahlung in einem Teilchenbeschleuniger oder alternativ in Kernreaktoren generiert werden und bildet eine indirekt ionisierende Strahlung mit hohem Durchdringungsvermögen. Die Anlagen zur Erzeugung einer Neutronenstrahlung können relativ zu anderen Strahlungsarten kostenintensiv sein. Typische Energien der Neutronenstrahlung können z. B. bei wenigen bis einigen 100 MeV,zwischen 10 MeV und 100 MeV oder zwischen 40 MeV und 80 MeV liegen, wobei die bestrahlten Materialien analog zur Protonenstrahlung radioaktiv werden können, was zu einem Verbleib der Materialien an der Bestrahlungsanlage auf längere bis unbestimmte Zeit führen kann.

Eine Strahlung aus schweren Ionen, sogenannten Schwer-Ionen kann in einem Teilchenbeschleuniger generiert werden und weist ein sehr geringes Durchdringungsvermögen auf, wobei ein für das Verfahren nutzbarer Energiebereich z. B. bei mehreren 100 bis 1.000 MeV, zwischen 200 MeV und 800 MeV, 400 MeV und 700 MeV oder 500 MeV bis 600 MeV liegen kann. Im Vergleich zu anderen Strahlungsarten kann eine Anlage zur Generierung einer Schwer-lonenstrahlung sehr kostenintensiv sein.

Insgesamt alle der oben beschriebenen Strahlungsarten abhängig von den jeweils zu bestrahlenden Elementen, für die hier beschriebenen Verfahren nutzbar.

Möglicherweise können kommerzielle Bestrahlungseirichtungen, welche Elektronenbeschleuniger oder Cobalt-60 (Co-60) zur Sterilisation und Materialbearbeiturig anbieten, für ein Verfahren zum Löschen von Informationen und Daten benutzt werden. Dabei ist generell zu sagen, dass Co-60 eine geringe Dosisleistung bei hoher Durchdringung bietet, während Elektronen eine hohe Dosisleistung bei geringer Durchdringung bieten.

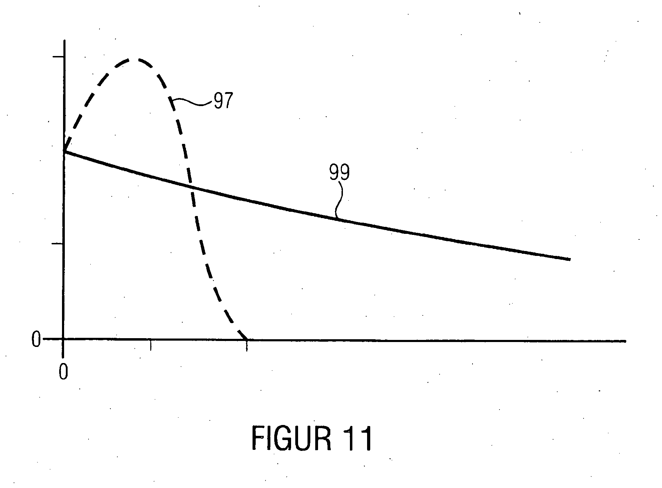

Fig. 11 zeigt eine schematische Gegenüberstellung einer Elektronenstrahlung mit einer Strahlungsenergie von 5 MeV, dargestellt in der gestrichelten Linie 97 gegenüber einer Co-60 Strahlung, die eine γ-Strahlung bildet und als durchgezogene Linie 99 dargestellt ist Eine Abszisse des Graphen zeigt ein Flächengewicht zu bestrahlender Objekte. An der Ordinate ist prozentual, also relativ, die Dosis der jeweiligen Strahlung in Prozent aufgetragen. Bei einem Flächengewicht nahe Null, also bei Objekten mit sehr geringer Dichte, weisen Elektronenstrahlung und Gammastrahlung 97 und 99 eine relative Durchdringungsfähigkeit von 100% auf, beziehungsweise geben eine Dosis von 100% an das bestrahlte Objekt ab. Die Kurve 97 der Elektronenstrahlung steigt mit steigendem Flächengewicht zunächst an, bis ein Wert von ca 150% der Dosis erreicht ist, um danach mit steigendem Flächengewicht zügig auf eine Dosis von 0% abzufallen. Demgegenüber zeigt die Kurve 99 der Gammastrahlung einen kontinuierlichen Abfall der Dosis bei steigendem Flächengewicht, was auf ein geringes Durchdringungsvermögen hinweist.

Alternative Ausführungsformen zeigen eine Bestrahlungsanläge unter Verwendung von Gammastrahlung, wie sie kommerziell eingesetzt wird. Eine derartige Anlage könnte für ein Verfahren zum Löschen von Informationen auf Halbleiterbausteinen genutzt werden. Zu bestrahlende Löschobjekte, bspw. Speichervorrichtungen, Halbleiterbausteine oder Systeme können auf Paletten gestapelt und/oder von einem verplombten Käfig umgeben sein und so um die Co-60-Quelle bewegt werden. Um eine große bis optimale Homogenität der Strahlungseinwirkung zu gewährleisten, kann die Palette gedreht und von mehreren Seiten bestrahlt werden. Die Bestrahlungszeit kann so gewählt werden, dass die Geräte im Inneren der Behälter eine erforderliche Solldosis, beispielsweise 1 kGy, 5 kGy, 10 kGy, 15 kGy, 20 kGy oder 25 kGy absorbieren, während sie um die Strahlungsquelle bewegt werden. Dabei kann die erreichte Dosis beispielsweise durch ein geeignetes Indikatorelement oder ein Dosimeter verifiziert werden. Im Gegensatz zu Sterilisierungsanwendungen verlangt ein mit der Vorrichtung ausgeführtes Verfahren : keine Dosisobergrenze, das bedeutet, dass beispielsweise innerhalb eines Behälters außen angeordnete Geräte eine beliebig hohe Dosis absorbieren können, da lediglich eine Solldosis mit der Bedeutung einer mindestens zu absorbierenden Dosis für jedes Gerät definiert ist. Bis diese Solldosis von einem Gerät in der Mitte des Behälters absorbiert ist, kann eine höhere Dosis von einem relativ zur Mitte des Behälters weiter außen liegenden Geräts absorbiert sein.

Aufgrund der geringen Durchdringung und hohen Dosisleistung bis zu 10 MGy/h kann bei Elektronenbeschleunigern allgemein eine Transporteinrichtung, etwa eine Fließbandanordnung, genutzt werden. Aufgrund der geringen Durchdringung kann es vorteilhaft sein, die Behälter dünn, eventuell nur jeweils gerätehoch zu gestalten und zu verplomben. Die verplombten Pakete können dann auf einem Fließband unter dem, beispielsweise mittels eines Scanners aufgeweiteten Elektronenstrahl hindurch bewegt werden. Wird ein Paket gedreht und auch von einer anderen Seite bestrahlt, so würde sich beispielsweise bei einem 10 MeV-Elektronenstrahl und einer Dichte der Geräte von 1,4 g/cm³ eine Prozessdicke von ca. 5,8cm ergeben.

In anderen Worten können Anlagen, die bislang beispielsweise zur Sterilisation von Medizinprodukten oder Lebensmitteln oder zur Kunststoffvernetzung eingesetzt werden, für den Zweck dieses Verfahrens genutzt öder umgerüstet werden.

Obwohl in vorangegangenen Ausführungsbeispielen Floating-Gates in Speicherelementen und Geräte beschrieben werden, auf denen negative Ladungsträger gespeichert werden um Informationen öder Daten zu repräsentieren, können auch andere, bspw. positive Ladungsträger, auf den Floating-Gates zur Repräsentation von Informationen oder Daten gespeichert sein. Eine Löschung von Ladungsträgern auf dem Floating-Gate umfasst dann eine Reduzierung von bspw. positiven Ladungsträgern oder deren Konzentrationen auf dem Floating-Gate. Die obige Beschreibung ist somit entsprechend anwendbar.

Obwohl manche Aspekte im Zusammenhang mit einer Vorrichtung beschrieben wurden versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten , werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Verfahren (100) zum Löschen von Informationen, die auf einem elektronischen Halbleiterbaustein (64) in einer Vielzahl von nicht flüchtigen Speicherelementen (66), die ein Floating-Gate aufweisen, gespeichert sind, mit folgendem Schritt:
Bestrahlen (102) des Halbleiterbausteins (64) mit einer Löschstrahlung (56) bis eine Solldosis der Löschstrahlung (56) von dem Halbleiterbaustein (64) absorbiert ist;
wobei die Löschstrahlung (56) den Halbleiterbaustein (64) durchdringt und zumindest ein Teil der Löschstrahlung (56) in dem Halbleiterbaustein (64) unter Auftreten eines lonisationseffektes (A; B; C) absorbiert wird, wobei bei Erreichen der Solldosis durch den lonisationseffekt (A; B; C) die Konzentration von auf den Speicherelementen (66) gespeicherten Ladungsträgern (46) derart beeinflusst wird, dass die statistische Verteilung (12; 16; 16-1; 16-2; 16-3) der Schwellenspannungen der Speicherelemente (66) einen gemeinsamen zusammenhängenden Bereich (26) bildet, so dass auch bei Veränderung einer Lesespannung nicht mehr zwischen programmierten und unprogrammierten Speicherzellen unterschieden werden kann;
wobei die Sölldosis der Löschstrahlung (56) so gewählt ist, dass die statistische Verteilung (12; 16; 16-1; 16-2; 16-3) dauerhaft und irreversibel den zusammenhängenden Bereich (26) bildet; und
wobei durch den lonisationseffekt (A; B; C) die Konzentration der Ladungsträger (46) auf den Speicherelementen (66) verändert wird, so dass die Konzentration von Ladungsträgern (46) auf den Speicherelementen (66) nach dem Bestrahlungsvorgang unabhängig von der Konzentration von Ladungsträgern (46) vor dem Bestrahlungsvorgang ist.

2. Verfahren (100; 200) gemäß einem der vorangehenden Ansprüche, wobei der Schritt des Bestrahlens (102; 202) mehrere Einzelschritte aufweist, um die Solldosis schrittweise zu erreichen.

3. Verfahren (100; 200) gemäß Anspruch 2, bei dem die Solldosis zumindest 1 kGy beträgt.

4. Verfahren (100; 200) gemäß einem der vorangehenden Ansprüche, bei dem der zusammenhängende Bereich (26) der statistischen Verteilung der Schwellenspannung einen Überlappungsbereich (24) hinsichtlich eines ursprünglichen ersten und zweiten logischen Zustands von zumindest 30 % aufweist.

5. Verfahren (100; 200) gemäß einem der vorangehenden Ansprüche das ferner folgenden Schritt aufweist:
Bestrahlen eines . Indikatorelementes gemeinsam mit dem Halbleiterbaustein (64), wobei das Indikatorelement ausgebildet ist, um bei Erreichen der Solldosis eine physikalische oder chemische Eigenschaft zu verändern.

6. Verfahren (100; 200) gemäß einem der vorangehenden Ansprüche, wobei sich der. Halbleiterbaustein (64) in einem für die Löschstrahlung (56) durchlässigen Behälter (68; 68-1; 68-2; 68-3) befindet, und wobei beim Schritt des Bestrahlens (102; 202) der Behälter (68; 68-1 ;68-2 ;68-3) mit dem darin angeordneten Halbleiterbaustein (64) der Löschstrahlung (56) ausgesetzt wird.

7. Verfahren (100; 200) gemäß Anspruch 6, wobei sich eine Mehrzahl von Halbleiterbausteinen (64) oder die Halbleiterbausteine (64) aufweisende Geräte in dem Behälter (68; 68-1 ;68-2 ;68-3) befinden.

8. Verfahren (100; 200) gemäß einem der vorangegangenen Ansprüche, wobei der Schritt des Bestrahlens (102; 202) unter verschiedenen Einfallswinkeln der Löschstrahlung (56) auf den Halbleiterbaustein (64) durchgeführt wird.

9. Verfahren (100; 200) gemäß einem der vorangegangenen Ansprüche, das ferner folgenden Schritt umfasst:
Bewegen des Halbleiterbausteins (64) mittels einer Transporteinrichtung (86) relativ zu einer Strahlungsquelle (71) in einen Bestrahlungsbereich, wobei der Halbleiterbaustein (64) solange in dem Bestrahlungsbereich behalten wird, bis die Solldosis von dem Halbleiterbaustein (64) absorbiert wird.

10. Verfahren (100; 200) gemäß einem der vorangegangenen Ansprüche, bei dem die Speicherelemente (66) als Flash-Speicherelemente ausgeführt sind und ein Floating-Gate (32) und einem das Floating-Gate (32) umgebenden Isolationsmaterial (42a; 42b) aufweisen, wobei eine auf dem Floating-Gate (32) gespeicherte elektrische Ladung irgendeinen der möglichen logischen Speicherzustand des jeweiligen Speicherelements (66) vorgibt.

11. Vorrichtung (80; 90; 95) zum Löschen von Informationen, die auf einem elektronischen Halbleiterbaustein (64) in einer Vielzahl von nicht flüchtigen Speicherelementen (66), die ein Floating-Gate aufweisen, gespeichert sind, mit folgendem Merkmal:
einer Bestrahlungseinrichtung (69), die ausgebildet ist, um den Halbleiterbaustein einer Löschstrahlung (56) auszusetzen, bis eine Solldosis von dem Halbleiterbaustein (64) absorbiert ist;
wobei die Löschstrahlung (56) den Halbleiterbaustein (64) durchdringt und zumindest ein Teil der Löschstrahlung (56) in dem Halbleiterbaustein (64) unter Auftreten eines lonisationseffektes (A; B; C) absorbiert wird, wobei der Ionisationseffekt (A; B; C) die Menge der auf den Speicherelementen (66) gespeicherte Ladungsträger (46) derart beeinflusst, dass die statistische Verteilung (12; 16; 16-1; 16-2; 16-3) der Schwellenspannungen einen gemeinsamen zusammenhängenden Bereich (26) bildet, so dass auch bei Veränderung einer Lesespannung nicht mehr zwischen programmierten und unprogrammierten Speicherzellen unterschieden werden kann;
wobei die Solldosis der Löschstrahlung (56) so gewählt ist, dass die statistische Verteilung (12; 16; 16-1; 16-2; 16-3) dauerhaft und irreversibel den zusammenhängenden Bereich (26) bildet; und
wobei durch den lonisationseffekt (A; B; C) die Konzentration der Ladungsträger (46) auf den Speicherelementen (66) verändert wird, so dass die Konzentration von Ladungsträgern (46) auf den Speicherelementen (66) nach dem Bestrahlungsvorgang unabhängig von der Konzentration von Ladungsträgern (46) vor dem Bestrahlungsvorgang ist.

12. Vorrichtung (80; 90; 95) gemäß Anspruch 11 bei der die Bestrahlungseinrichtung (69) ferner ausgebildet ist, um einen für die Löschstrahlung (56) durchlässigen Behälter (68; 68-1; 68-2; 68-3) zu bestrahlen, in dem sich der Halbleiterbaustein (64) befindet, so dass der Behälter mit den darin angeordneten Halbleiterbausteinen (64) der Löschstrahlung (56) ausgesetzt wird.

13. Vorrichtung (80; 90; 95) gemäß Anspruch 11 oder 12, bei der die Bestrahlungseinrichtung (69) ferner ausgebildet ist, um den Halbleiterbaustein (64) unter verschiedenen Einfallswinkeln mit der Löschstrahlung (56) zu bestrahlen.

14. Vorrichtung (80; 90; 95) gemäß einem der Ansprüche 11 bis 13, ferner mit einer Transporteinrichtung (86), die ausgebildet ist, um den Halbleiterbaustein (64) mittels der Transporteinrichtung (86) relativ zu einer Strahlungsquelle (71) in einen Bestrahlungsbereich zu bewegen, und den Halbleiterbaustein (64) solange in dem Bestrahlungsbereich zu behalten, bis die Solldosis von dem Halbleiterbaustein (64) absorbiert ist.

15. Vorrichtung mit einem irreversibel gelöschten. Halbleiterbaustein, der mit einem Löschverfahren gemäß einem der Ansprüche 1-10 gelöscht wurde.

## Claims

1. A method (100) of erasing information stored on an electronic semiconductor component (64) in a plurality of non-volatile memory elements (66) comprising floating gates, comprising:
irradiating (102) the semiconductor component (64) with erasing radiation (56) until a target dose of the erasing radiation (56) has been absorbed by the semiconductor component (64);
wherein the erasing radiation (56) penetrates the semiconductor component (64) and at least part of the erasing radiation (56) is absorbed in the semiconductor component (64) with an ionization effect (A; B; C) occurring, wherein, when the target dose is reached, the concentration of charge carriers (46) stored on the memory elements (66) is influenced by the ionization effect (A; B; C) such that the statistical distribution (12; 16; 16-1; 16-2; 16-3) of the threshold voltages of the memory elements (66) forms a shared contiguous region (26), so that even in the event of a change in a reading voltage, one may no longer differentiate between programmed and unprogrammed memory cells;
wherein the target dose of the erasing radiation (56) is selected such that the statistical distribution (12; 16; 16-1; 16-2; 16-3) permanently and irreversibly forms the contiguous region (26); and
wherein the concentration of the charge carriers (46) on the memory elements (66) is changed by the ionization effect (A; B; C) such that the concentration of charge carriers (46) on the memory elements (66) after the irradiation process is independent of the concentration of the charge carriers (46) before the irradiating process.

2. The method (100; 200) in accordance with any of the preceding claims, wherein the step of irradiating (102; 202) comprises several individual steps in order to achieve the target dose in steps.

3. The method (100; 200) in accordance with claim 2, wherein the target dose is at least 1 kGy.

4. The method (100; 200) in accordance with any of the preceding claims, wherein the contiguous region (26) of the statistical distribution of the threshold voltage comprises an overlap region (24) of at least 30 % relative to an original first and second logic state.

5. The method (100; 200) in accordance with any of the preceding claims, further comprising:
irradiating an indicator element together with the semiconductor component (64), wherein the indicator element is configured to change a physical or chemical characteristic when reaching the target dose.

6. The method (100; 200) in accordance with any of the preceding claims, wherein the semiconductor component (64) is located in a container (68; 68-1; 68-2; 68-3) transparent for the erasing radiation (56), and wherein in the step of irradiating (102; 202) the container (68; 68-1; 68-2; 68-3) with the semiconductor component (64) arranged therein is exposed to the erasing radiation (56).

7. The method (100; 200) in accordance with claim 6, wherein a plurality of semiconductor components (64) or units comprising the semiconductor components (64) are located in the container (68; 68-1; 68-2; 68-3).

8. The method (100; 200) in accordance with any of the preceding claims, wherein the step of irradiating (102; 202) is performed at different incident angles of the erasing radiation (56) onto the semiconductor component (64).

9. The method (100; 200) in accordance with any of the preceding claims, further comprising:
moving the semiconductor component (64) relative to a radiation source (71) into a radiation region by means of transport means (86), wherein the semiconductor component (64) is kept in the irradiation region until the target dose has been absorbed by the semiconductor component (64).

10. The method (100; 200) in accordance with any of the preceding claims, wherein the memory elements (66) are implemented to be flash memory elements and comprise a floating gate (32) and an insulating material (42a; 42b) surrounding the floating gate (32), wherein an electrical charge stored on the floating gate (32) predetermines any of the possible logic memory states of the respective memory element (66).

11. A device (80; 90; 95) for erasing information stored on an electronic semiconductor component (64) in a plurality of non-volatile memory elements (66) comprising floating gates, comprising:
irradiating means (69) configured to expose the semiconductor component to erasing radiation (56) until a target dose has been absorbed by the semiconductor component (64);
wherein the erasing radiation (56) penetrates the semiconductor component (64) and at least part of the erasing radiation (56) is absorbed in the semiconductor component (64) with an ionization effect (A; B; C) occurring, wherein the ionization effect (A; B; C) influences the quantity of charge carriers (46) stored on the memory elements (66) such that the statistical distribution (12; 60; 68-1; 68-2; 68-3) of the threshold voltages forms a shared contiguous region (26), so that even in the event of a change in a reading voltage, one may no longer differentiate between programmed and unprogrammed memory cells;
wherein the target dose of the erasing radiation (56) is selected such that the statistical distribution (12; 16; 16-1; 16-2; 16-3) permanently and irreversibly forms the contiguous region (26); and
wherein the concentration of the charge carriers (46) on the memory elements (66) is changed by the ionization effect (A; B; C) such that the concentration of charge carriers (46) on the memory elements (66) after the irradiation process is independent of the concentration of charge carriers (46) before the irradiating process.

12. The device (80; 90; 95) in accordance with claim 11, wherein the irradiating means (69) is additionally configured to irradiate a container (68; 68-1; 68-2; 68-3) transparent for the erasing radiation (56) in which the semiconductor component (64) is located such that the container with the semiconductor components (64) arranged therein is exposed to the erasing radiation (56).

13. The device (80; 90; 95) in accordance with claim 11 or 12, wherein the irradiating means (69) is additionally configured to irradiate the semiconductor component (64) with the erasing radiation (56) at different incident angles.

14. The device (80; 90; 95) in accordance with any of claims 11 to 13, further comprising transport means (86) configured to move the semiconductor component (64) relative to a radiation source (71) into an irradiation region by means of the transport means (86) and to keep the semiconductor component (64) in the irradiating region until the target dose has been absorbed by the semiconductor component (64).

15. A device comprising an irreversibly erased semiconductor component having been erased using a erasing method in accordance with any of claims 1 to 10.

## Revendications

1. Procédé (100) pour effacer des informations qui sont mémorisées sur un dispositif électronique à semi-conducteurs (64) dans une pluralité d'éléments de mémoire non volatile (66) présentant une grille flottante, aux étapes suivantes consistant à:
irradier (102) le dispositif à semi-conducteurs (64) par un rayonnement d'effacement (56) jusqu'à ce que soit absorbée une dose de consigne du rayonnement d'effacement (56) par le dispositif à semi-conducteurs (64);
dans lequel le rayonnement d'effacement (56) pénètre dans le dispositif à semi-conducteurs (64) et au moins une partie du rayonnement d'effacement (56) est absorbée dans le dispositif à semi-conducteurs (64) en produisant un effet d'ionisation (A; B; C), dans lequel, lorsque la dose de consigne est atteinte par suite de l'effet d'ionisation (A; B; C), la concentration de porteurs de charge (46) mémorisés sur les éléments de mémoire (66) est influencée de sorte que la répartition statistique (12; 16; 16-1; 16-2; 16-3) des tensions de seuil des éléments de mémoire (66) forme une zone cohérente commune (26), de sorte que, même en cas de modification d'une tension de lecture, il ne puisse plus être distingué entre les cellules de mémoire programmées et non programmées;
dans lequel la dose de consigne du rayonnement d'effacement (56) est choisie de sorte que la répartition statistique (12; 16; 16-1; 16-2; 16-3) forme de manière permanente et irréversible la zone cohérente (26); et
dans lequel la concentration des porteurs de charge (46) sur les éléments de mémoire (66) est modifiée par l'effet d'ionisation (A; B; C), de sorte que la concentration de porteurs de charge (46) sur les éléments de mémoire (66) après l'opération d'irradiation soit indépendante de la concentration de porteurs de charge (46) avant l'opération d'irradiation.

2. Procédé (100; 200) selon l'une des revendications précédentes, dans lequel l'étape d'irradiation (102; 202) comprend plusieurs étapes individuelles pour atteindre graduellement la dose de consigne.

3. Procédé (100; 200) selon la revendication 2, dans lequel la dose de consigne est d'au moins 1 kGy.

4. Procédé (100; 200) selon l'une des revendications précédentes, dans lequel la zone cohérente (26) de la répartition statistique de la tension de seuil présente une zone de chevauchement (24) en ce qui concerne un premier et un deuxième état logique original d'au moins 30%.

5. Procédé (100; 200) selon l'une des revendications précédentes, présentant par ailleurs l'étape suivante consistant à:
irradier un élément indicateur ensemble avec le dispositif à semi-conducteurs (64), où l'élément indicateur est conçu pour modifier, lorsque la dose de consigne est atteinte, une propriété physique ou chimique.

6. Procédé (100; 200) selon l'une des revendications précédentes, dans lequel le dispositif à semi-conducteurs (64) se trouve dans un conteneur (68; 68-1; 68-2; 68-3) perméable au rayonnement d'effacement (56), et dans lequel, à l'étape d'irradiation (102; 202), le conteneur (68; 68-1; 68-2; 68-3) avec le dispositif à semi-conducteurs (64) y disposé est exposé au rayonnement d'effacement (56).

7. Procédé (100; 200) selon la revendication 6, dans lequel une pluralité de dispositifs à semi-conducteurs (64) ou d'appareils présentant les dispositifs à semi-conducteurs (64) se trouvent dans le conteneur (68; 68-1; 68-2; 68-3).

8. Procédé (100; 200) selon l'une des revendications précédentes, dans lequel l'étape d'irradiation (102; 202) est réalisée selon différents angles d'incidence du rayonnement d'effacement (56) sur le dispositif à semi-conducteurs (64).

9. Procédé (100; 200) selon l'une des revendications précédentes, comportant par ailleurs l'étape suivante consistant à:
déplacer le dispositif à semi-conducteurs (64) au moyen d'un dispositif de transport (86) par rapport à une source de rayonnement (71) dans une zone d'irradiation, où le dispositif à semi-conducteurs (64) est maintenu dans la zone de rayonnement jusqu'à ce que la dose de consigne soit absorbée par le dispositif à semi-conducteurs (64).

10. Procédé (100; 200) selon l'une des revendications précédentes, dans lequel les éléments de mémoire (66) sont réalisés sous forme d'éléments de mémoire flash et présentent une grille flottante (32) et un matériau isolant (42a; 42b) entourant la grille flottante (32), où une charge électrique mémorisée sur la grille flottante (32) indique l'un quelconque des états de mémoire logique possibles de l'élément de mémoire respectif (66).

11. Dispositif (80; 90; 95) destiné à effacer des informations mémorisées sur un dispositif électronique à semi-conducteurs (64) dans une pluralité d'éléments de mémoire non volatile (66) qui présentent une grille flottante, avec la caractéristique suivante:
un dispositif d'irradiation (69) qui est conçu pour exposer le dispositif à semi-conducteurs à un rayonnement d'effacement (56) jusqu'à ce que soit absorbée une dose de consigne par le dispositif à semi-conducteurs (64);
dans lequel le rayonnement d'effacement (56) pénètre dans le dispositif à semi-conducteurs (64) et au moins une partie du rayonnement d'effacement (56) est absorbée dans le dispositif à semi-conducteurs (64) en produisant un effet d'ionisation (A; B; C), dans lequel l'effet d'ionisation (A; B; C) influence la quantité de porteurs de charge (46) mémorisés sur les éléments de mémoire (66) de sorte que la répartition statistique (12; 16; 16-1; 16-2; 16-3) des tensions de seuil forme une zone cohérente commune (26), de sorte que, même en cas de modification d'une tension de lecture, il ne puisse plus être distingué entre les cellules de mémoire programmées et non programmées;
dans lequel la dose de consigne du rayonnement d'effacement (56) est choisie de sorte que la répartition statistique (12; 16; 16-1; 16-2; 16-3) forme de manière permanente et irréversible la zone cohérente (26); et
dans lequel est modifiée, par suite de l'effet d'ionisation (A; B; C), la concentration des porteurs de charge (46) sur les éléments de mémoire (66), de sorte que la concentration de porteurs de charge (46) sur les éléments de mémoire (66) après l'opération d'irradiation soit indépendante de la concentration de porteurs de charge (46) avant l'opération d'irradiation.

12. Dispositif (80; 90; 95) selon la revendication 11, dans lequel le dispositif d'irradiation (69) est par ailleurs conçu pour irradier un conteneur (68; 68-1; 68-2; 68-3) perméable au rayonnement d'effacement (56) dans lequel se trouve le dispositif à semi-conducteurs (64), de sorte que le conteneur avec les dispositifs à semi-conducteurs (64) y disposés soit exposé au rayonnement d'effacement (56).

13. Dispositif (80; 90; 95) selon la revendication 11 ou 12, dans lequel le dispositif d'irradiation (69) est par ailleurs conçu pour irradier le dispositif à semi-conducteurs (64) selon différents angles d'incidence par le rayonnement d'effacement (56).

14. Dispositif (80; 90; 95) selon l'une des revendications 11 à 13, par ailleurs avec un dispositif de transport (86) qui est réalisé pour déplacer le dispositif à semi-conducteurs (64) au moyen du dispositif de transport (86) par rapport à une source de rayonnement (71) dans une zone d'irradiation, et pour maintenir le dispositif à semi-conducteurs (64) dans la zone d'irradiation, jusqu'à ce que la dose de consigne soit absorbée par le dispositif à semi-conducteurs (64).

15. Dispositif avec un dispositif à semi-conducteurs effacé de manière irréversible qui a été effacé par un procédé d'effacement selon l'une des revendications 1 à 10.
